# EUROPEAN PATENT APPLICATION

(11) **EP 2 196 851 A1**
(43) Date of publication of application: **16.06.2010**
(21) Application number: 08171484.2
(22) Date of filing: 12.12.2008
(51) Int. Cl.: G03F 7/033, G03F 7/029

(54) **Negative working lithographic printing plate precursors comprising a reactive binder containing aliphatic bi- or polycyclic moieties**

(71) Applicant: Eastman Kodak Company, Rochester NY 14650-2201 (US)
(72) Inventor: Balbinot, Domenico, Dr., 37520 Osterode (DE); Jarek, Mathias, Dr., 37581 Bad Gandersheim (DE); Simpson, Christopher, Dr., 37520 Osterode (DE)
(74) Representative: Vossius & Partner

(57) **Abstract**

Negative working lithographic printing plate precursors are described wherein the imageable layer comprises a polymeric binder comprising (a) repeating units with pendant acid groups and (b) repeating units with pendant ethylenically unsaturated groups which are integral units of aliphatic bi- or polycyclic structures.

## Description

The present invention relates to lithographic printing plates precursors comprising a negative working coating comprising a reactive binder; the invention also relates to a method for imaging such precursors.

Lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, however, the printing ink is first transferred to an intermediate material, referred to as blanket, which then in turn transfers the printing ink onto the surface of the material on which the image is to be formed; this technique is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic. The differentiation between image and non-image areas takes place during exposure, for which a film is attached to the printing plate precursor under vacuum in order to guarantee good contact. The plate is then exposed by means of a radiation source part of which is comprised of UV radiation. When a positive plate is used, the area on the film corresponding to the image on the plate is so opaque that the light does not reach the plate, while the area on the film corresponding to the non-image area is clear and allows light to permeate the coating, whose solubility increases. In the case of a negative plate, the opposite takes place: The area on the film corresponding to the image on the plate is clear, while the non-image area is opaque. The coating beneath the clear film area is hardened (for instance by photopolymerization) due to the incident light, while the area not affected by the light is removed during developing. The light-hardened surface of a negative working plate is therefore oleophilic and accepts printing ink, while the non-image area that used to be coated with the coating removed by the developer is desensitized and therefore hydrophilic.

Alternatively, the plate can also be imagewise exposed digitally without a film e.g. by lasers. According to recent developments, plate precursors with heat-sensitive layers are used wherein by imagewise direct heating or irradiation with IR radiation that is converted into heat, differences in the developer solubility of the heated and unheated areas of the coating are generated.

Sometimes water-soluble polymers are used as temporary coatings (sometimes called "overcoat") on lithographic printing plate precursors having an oxygen-sensitive coating like a photopolymerizable coating. The water-soluble polymers have the function of protecting the coating from atmospheric oxygen during storage, exposure and in particular during the time between exposure and further processing (development and the like). During that time period the temporary coating has to exhibit a sufficient adhesion to the light-sensitive substrate so that safe handling (manufacture, packing, transport, exposure etc.) is guaranteed without tearing of the layers. Prior to the development the overcoat can is removed, preferably by washing with water or the overcoat is dissolved within the developer together with the non-image parts.

Usually, a substrate, in particular an aluminum substrate with aluminum oxide layer, is provided with a hydrophilic protective layer (also referred to as "interlayer") before the radiation-sensitive coating is applied. This hydrophilic layer improves the water acceptance of the (non-printing) background areas of a lithographic printing plate and improves the repulsion of the printing ink in these areas. A suitable hydrophilic protective layer also ensures that during developing the soluble portions of the radiation-sensitive layer are removed easily and residue-free from the substrate so that clean background areas are obtained during printing.

Without such a residue-free removal, what is referred to as toning would occur during printing, i.e. the background areas would accept printing ink.

For a clean printed image it is necessary that the image areas (i.e. the imagewise remaining coating) accept the printing ink well, while the non-image areas (i.e. the imagewise revealed substrate, such as e.g. an aluminum substrate) should not accept the printing ink. In order to protect the imagewise revealed substrate, such as e.g. an aluminum substrate, against fingerprints, the formation of aluminum oxide, corrosion and mechanical attacks, such as scratches, when the printing plate is mounted in the printing machine, i.e. to maintain and possibly improve the hydrophilic nature of the non-image areas, the developed printing plate is usually subjected to a "gumming" treatment (also referred to as "finishing"). Gumming the plate prior to storing it or before long periods of standstill of the printing machine ensures that the non-image areas remain hydrophilic. When printing is started, the gumming solution has to be able to be washed off the plate quickly with the fountain solution so that the image areas are capable of accepting ink immediately. Gumming solutions have been known for a long time and are for instance disclosed in DE 29 26 645, DE 20 42 217 A1, US 4,880,555 A1, US 4,033,919 A1, and US 4,162,920 A1.

In DE 29 03 270 A1 a negative working UV-sensitive composition is disclosed which comprises a (meth)acrylic ester of an epoxy resin.

A process for preparing a UV curable polymer with pendant acrylate or methacrylate groups is described in US 4,035,321.

WO 89/06659 discloses cellulose esters with pendant (meth)acrylic or α-methylstyrene moieties which form insoluble crosslinked networks upon exposure to UV radiation. Coatings prepared from such polymers show good resistance to surface damage caused by solvents, stains and abrasion.

Polyurethanes with (meth)acryloyl groups as binders for energy curable powder lacquer are described in EP 0 410 242 A2.

WO 95/12147 discloses polyvinyl acetal binder resins for photosensitive compositions wherein the binder comprises pendant (meth)acryl groups.
High speed negative-working thermal printing plates comprising an imageable composition which comprises an allyl-functional polymeric binder are disclosed in WO 2004/014652.

EP 0 217 137 A2 discloses photopolymerizable compositions useful for the preparation of high speed UV sensitive elements; the compositions comprise an acrylic copolymer containing only 15 to 25 % by weight dicyclopentenyl (meth)acrylate. The print run length and scratch resistance of printing plates obtained does, however, not meet nowadays standards.

WO 02/073307 discloses photolithographic sensitive coated substrates comprising on a substrate a thermally cured undercoat and a radiation-sensitive resist topcoat, wherein the thermally cured undercoat was derived from a composition comprising an amino-crosslinking agent, a thermal acid generator and a hydroxyl-containing polymer which comprises pendant ester groups. The plate needs an undercoat formulation which is not a photosensitive layer. Said layer needs to be baked and is not removed with an aqueous developer but via plasma etching. Accordingly, said plate formulation cannot be developed in a single bath developing process.

EP 1 708 033 A2 describes a method for platemaking wherein the roughness of the substrate of the presensitized plate and the developing solution are selected in a specific way. The presensitized plate comprises an image recording layer which includes a polymerization initiator, a polymerizable compound and a hydrophobic binder polymer, wherein the hydrophobic binder, which can be crosslinkable, is not soluble in water and aqueous alkaline solutions. However, a hydrophobic non-water soluble binder can not be removed in a single bath developing process since non-watersoluble binder is likely to form sludge in the processor which is not desirable.

US 2007/0,128,548 A1 refers to a photosensitive composition comprising a triazine-based photoactive compound containing oxime ester, a polymerizable compound and an alkalisoluble resin binder; the binder is for example a 70 : 30 copolymer of benzylmethacrylate and methacrylic acid.

DE 25 30 502 A1 describes a method for simultaneously developing and gumming printing plates, wherein the liquid used comprises besides water, a small amount of organic solvent, a water-soluble colloid like dextrin and a salt.

It is the object of the present invention to provide negative working lithographic printing plate precursors which show excellent speed and which can be developed within a short period of time with a processing liquid which does not only remove the non-image areas but also provides a gumming; at the same time the obtained printing plate should show excellent scratch resistance and high print run length. It is a further object of the present invention to provide a process for imaging such precursors and a radiation-sensitive composition for preparing such precursors.

This object is surprisingly achieved by a negative working lithographic printing plate precursor, comprising:
(a) a substrate with a hydrophilic surface on at least one side thereof
(b) an imageable coating on the hydrophilic surface of the substrate, comprising:
   (i) at least one low molecular weight free-radical polymerizable component
   (ii) at least one radical forming component selected from photoinitiators and sensitizer/coinitiator systems which absorbs radiation of a wavelength in the range of 250 to 1200 nm and is capable of initiating a free-radical polymerization
      and
   (iii) at least one reactive polymeric binder comprising repeating units A, B, and optionally C

      -(A)ₓ-, -(B)y-, -(C)ₜ-,

      wherein x is 5 to 30 mol%
      y is 40 to 85 mol%
      t is 0 to 60 mol%

      A is at least one repeating unit comprising at least one pendant acid group
      B is at least one repeating unit comprising at least one pendant ethylenically unsaturated group which is an integral part of a bi- or polycyclic structure
         and
      C is at least one repeating unit derived from a (meth)acrylic acid ester or a (meth)acrylamide
      and optionally
(c) an oxygen-impermeable overcoat.

Within this invention the expression (meth)acrylic acid includes acrylic acid and methacrylic acid; the same applies to (meth)acrylate and similar expression.

Any embodiment or preferred embodiment described below can be combined with one or more other embodiments or preferred embodiments described below.

### PRECURSORS

The negative working precursors of the present invention can be sensitive to UV/VIS radiation or IR radiation. In general, the negative working lithographic printing plate precursors comprise: (i) a substrate, (ii) a negative-working radiation-sensitive coating and (iii) optionally an oxygen-impermeable overcoat and preferably consist of (i), (ii) and (iii)..

### Substrates

The substrate used for the precursors is preferably a dimensionally stable plate or foil-shaped material like one that has already been used as a substrate for printing matter. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred since it shows a remarkable degree of dimensional stability, is inexpensive and furthermore exhibits excellent adhesion to the radiation-sensitive coating. Furthermore, a composite film can be used wherein an aluminum foil has been laminated onto a plastic film, such as e.g. a polyethylene terephthalate film, or paper, or a plastic film onto which aluminum has been applied by means of vapor deposition. Preferred substrates are metal substrates, wherein the term "metal substrate" as used herein also encompasses composite films with the upper-most layer being a metal layer or foil

A metal substrate, in particular an aluminum substrate, is preferably subjected to a surface treatment, for example graining by brushing in a dry state or brushing with abrasive suspensions, or electrochemical graining, e.g. by means of a hydrochloric acid electrolyte or HNO₃, and optionally anodizing, e.g. in sulfuric acid or phosphoric acid. According to a preferred embodiment the metal substrate comprises an Al₂O₃-, ZnO-, SiO₂- or TiO₂-layer.

With the process of the present invention it is also possible to prepare lithographic printing plates which do not show toning although the oxide layer has defects.

An aluminum foil which preferably has a thickness of 0.1 to 0.7 mm, more preferred 0.15 to 0.5 mm, is an especially preferred substrate. It is preferred that the foil be grained (preferably electrochemically, for instance in hydrochloric acid or nitric acid) and then show an average roughness of 0.2 to 1 µm, especially preferred 0.3 to 0.8 µm.

According to an especially preferred embodiment, the grained aluminum foil was furthermore anodized (for instance in sulphonic acid). The layer weight of the resulting aluminum oxide is preferably 1.5 to 5 g/m², especially preferred 2 to 4 g/m².

A metal substrate can additionally be subjected to a posttreatment (so called "sealing") with an aqueous solution of e.g. alkali metal silicate, calcium zirconium fluoride, hexafluorosilicic acid, phosphate/fluoride, polyvinylphosphonic acid, vinylphosphonic acid copolymers, or phosphonic acid thereby providing a hydrophilizing layer (also referred to as "interlayer") on its surface.

The details of the above-mentioned substrate treatments are well known to the person skilled in the art.

### Negative working radiation-sensitive coating (UV/VIS and IR)

The negative working coating applied onto the substrate comprises (a) at least one radical forming component selected from photoinitiators and sensitizer/coinitiator systems which absorbs radiation of a wavelength in the range of 250 to 1,200 nm and is capable of initiating a free-radical polymerization, (b) a free-radical polymerizable component and (c) at least one reactive polymeric binder.

Preferably the negative working lithographic printing plate precursor comprises an oxygen impermeable overcoat on the negative working radiation sensitive coating.

The negative working coating according to the present invention is subjected to free radical polymerization upon exposure and does not contain any thermal acid generators. Furthermore, the negative working coating does not contain a triazine based photoactive compound containing oxime ester as for instance disclosed in US 2007/0128548.

### Radical forming component

The radiation-sensitive coating comprises at least one radical forming component selected from photoinitiators and sensitizer/coinitiator systems.

The radical forming component is selected such that it is capable of significant absorption in the range in which the radiation source to be used later on during imaging emits; preferably, the radical forming component shows an absorption maximum in that range. Thus, if the radiation-sensitive element is e.g. going to be imaged by means of an IR laser, the radical forming component should essentially absorb radiation in the range of about 750 to 1,200 nm and preferably show an absorption maximum in that range. On the other hand, if imaging is to be carried out by means of UV/VIS radiation, the radical forming component should essentially absorb radiation in the range of about 250 to 750 nm and preferably show an absorption maximum in that range. Suitable photoinitiators and/or sensitizers are known to the person skilled in the art, or it can easily be determined whether significant absorption occurs in the desired wave length range by means of simple tests (e.g. recording an absorption spectrum).

In the present invention, a photoinitiator is a compound capable of absorbing radiation when exposed and of forming free radicals by itself, i.e. without the addition of coinitiators. Examples of suitable photoinitiators absorbing UV or VIS radiation include triazine derivatives with 1 to 3 CX₃ groups (wherein every X is independently selected from a chlorine or bromine atom, and is preferably a chlorine atom), hexaarylbisimidazole compounds, benzoin ethers, benzil ketals, oxime ethers, oxime esters, α-hydroxy- or α-amino-acetophenones, acylphosphines, acylphosphine oxides, acylphosphine sulfides, metallocenes, peroxides etc. Examples of suitable triazine derivatives include 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, and 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine. Suitable oxime ethers and oxime esters are for example those derived from benzoin. Preferred metallocenes are for example titanocenes with two five-membered cyclodienyl groups such as e.g. cyclopentadienyl groups and one or two six-membered aromatic groups having at least one ortho-fluorine atom and optionally also one pyrryl group; most preferred metallocenes are bis(cyclopentadienyl)-bis-[2,6-difluoro-3-(pyrr-1-yl)-phenyl]titanium and dicyclopentadiene-bis-2,4,6-trifluorophenyl-titanium or zirconium.

In the present invention, a single photoinitiator or a mixture of two or more can be used.

The photoinitiators can be combined with one or more coinitiators; the addition of coinitiators can increase the effectiveness of the photoinitiation.

The amount of photoinitiator(s) is not particularly restricted; however, if photoinitiators are present, it is preferably in the range of 0.2 to 25 wt-%, based on the dry layer weight, especially preferred 0.5 to 15 wt-%.

A sensitizer as referred to in the present invention is a compound which can absorb radiation when it is exposed but which cannot by itself, i.e. without the addition of coinitiators, form free radicals.

All light-absorbing compounds that are photooxidizable or photoreducible or capable of transferring their excitation energy to receptor molecules are suitable sensitizers for use in the present invention. Examples of such dyes include cyanine dyes, merocyanine dyes, oxonol dyes, diarylmethane dyes, triarylmethane dyes, xanthene dyes, coumarin derivatives, ketocoumarin dyes, acridine dyes, phenazine dyes, quinoxaline dyes, pyrrylium dyes or thiapyrrylium dyes, azaanulene dyes (such as phthalocyanines and porphyrines), indigo dyes, anthraquinone dyes, polyarylenes, polyarylpolyenes, 2,5-diphenylisobenzofuranes, 2,5-diarylfuranes, 2,5-diarylthiofuranes, 2,5-diarylpyrroles, 2,5-diarylcyclopentadienes, poly-alylphenylenes, polyaryl-2-pyrazolines, carbonyl compounds such as aromatic ketones or quinones, e.g. benzophenone derivatives, Michler's ketone, thioxanthone derivatives, anthraquinone derivatives and fluorenone derivatives.

Coumarin sensitizers of formula (I) are for example suitable for the UV range of the electromagnetic spectrum: 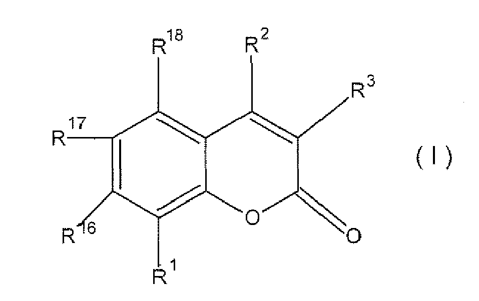 wherein
R¹, R¹⁶, R¹⁷ and R¹⁸ are independently selected from -H, a halogen atom, C₁-C₂₀ alkyl, -OH, -O-R⁴ and -NR⁵R⁶, wherein R⁴ is C₁-C₂₀ alkyl, C₅-C₁₀ aryl or C₆-C₃₀ aralkyl (preferably C₁-C₆ alkyl) and R⁵ and R⁶ are independently selected from a hydrogen atom and C₁-C₂₀ alkyl,
or R¹ and R¹⁶, R¹⁶ and R¹⁷ or R¹⁷ and R¹⁸ together form a 5- or 6-membered heterocyclic ring with a heteroatom, selected from N and O, in one or both positions adjacent to the phenyl ring shown in formula (I),
or R¹⁶ or R¹⁷ forms, together with its two adjacent substituents, a 5- or 6-membered heterocyclic ring with a heteroatom, selected from N and O, in one or both positions adjacent to the phenyl ring shown in formula (I),
wherein each formed 5- or 6-membered heterocyclic ring can independently be substituted with one or more C₁-C₆ alkyl groups,
with the proviso that at least one of R¹, R¹⁶, R¹⁷ and R¹⁸ is different from hydrogen and C₁-C₂₀ alkyl,
R² is a hydrogen atom, C₁-C₂₀ alkyl, C₅-C₁₀ aryl or C₆-C₃₀ aralkyl and
R³ is a hydrogen atom or a substituent selected from
-COOH, -COOR⁷, -COR⁸, -CONR⁹R¹⁰, -CN, C₅-C₁₀ aryl, C₆-C₃₀ aralkyl, a 5- or 6-membered heterocyclic optionally benzofused group, a group -CH=CH-R¹² and 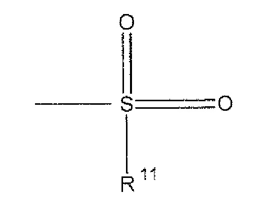 wherein R⁷ is C₁-C₂₀ alkyl, R⁸ is C₁-C₂₀ alkyl or a 5- or 6-membered heterocyclic group, R⁹ and R¹⁰ are independently selected from a hydrogen atom and C₁-C₂₀ alkyl, R¹¹ is C₁-C₁₂ alkyl or alkenyl, a heterocyclic non-aromatic ring or C₅-C₂₀ aryl optionally with a heteroatom, selected from O, S and N, and R¹² is C₅-C₁₀ aryl or a 5- or 6-membered heterocyclic, optionally aromatic, ring;
or R² and R³, together with the carbon atoms to which they are bonded, form a 5- or 6- membered, optionally aromatic, ring.

They are described in more detail e.g. in WO 2004/049068 A1.

Furthermore, bisoxazole derivatives and analogues of the formula (II) are suitable for the UV range 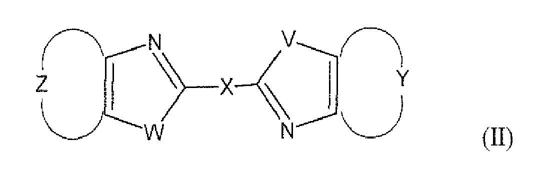
wherein X is a spacer group comprising at least one C-C double bond conjugated to the heterocycles,
Y and Z independently represent an optionally substituted fused aromatic ring and
V and W are independently selected from O, S and NR, wherein R is an alkyl, aryl or aralkyl group which can optionally be mono- or polysubstituted,
as described in more detail in WO 2004/074929 A2,
and oxazole compounds of the formula (III) 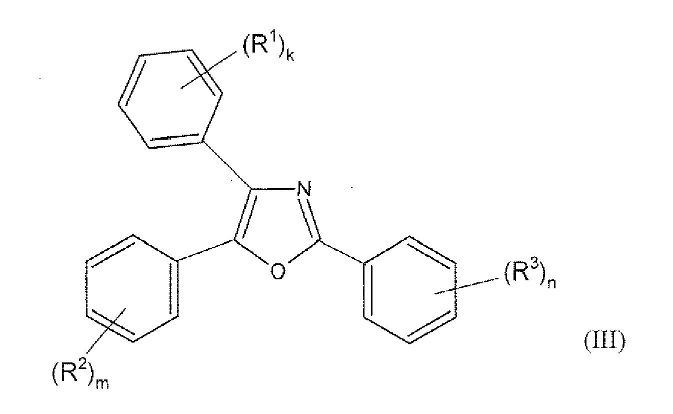
wherein each R¹, R² and R³ is independently selected from a halogen atom, an optionally substituted alkyl group, an optionally substituted aryl group, which may also be fused, an optionally substituted aralkyl group, a group -NR⁴R⁵ and a group -OR⁶,
wherein R⁴ and R⁵ are independently selected from a hydrogen atom, an alkyl, aryl or aralkyl group,
R⁶ is an optionally substituted alkyl, aryl or aralkyl group or a hydrogen atom, and k, m and n are independently 0 or an integer from 1 to 5,
as described in detail in WO 2004/074930 A2.

The 1,4-dihydropyridine compounds of formula (IV) as described in WO 2004/111731 A1 are an example of another class of sensitizers suitable for the UV range 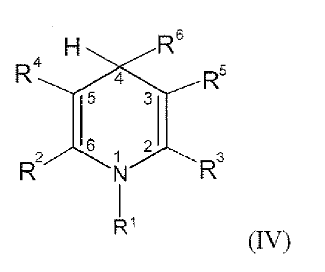 wherein
R¹ is selected from a hydrogen atom, -C(O)OR⁷, an optionally substituted alkyl group, an optionally substituted aryl group and an optionally substituted aralkyl group,
R² and R³ are independently selected from optionally substituted alkyl groups, optionally substituted aryl groups, CN and a hydrogen atom,
R⁴ and R⁵ are independently selected from -C(O)OR⁷, -C(O)R⁷, -C(O)NR⁸R⁹ and CN,
or R² and R⁴ together form an optionally substituted phenyl ring or a 5- to 7-membered carbocyclic or heterocyclic ring, wherein the unit 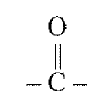
is present in the carbocyclic or heterocyclic ring adjacent to position 5 of the dihydropyridine ring and wherein the carbocyclic or heterocyclic ring optionally comprises additional substituents,
or both R² and R⁴ as well as R³ and R⁵ form either optionally substituted phenyl rings or 5- to 7-membered carbocyclic or heterocyclic rings, wherein the unit 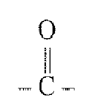 is present in the carbocyclic or heterocyclic rings adjacent to positions 3 and 5 of the dihydropyridine ring and wherein the carbocyclic or heterocyclic rings optionally comprise additional substituents,
or one of the pairs R²/R⁴ and R³/R⁵ forms a 5- to 7-membered carbocyclic or heterocyclic ring, wherein the unit 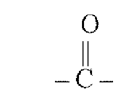 is present in the carbocyclic or heterocyclic ring adjacent to position 5 or 3 of the dihydropyridine ring and wherein the carbocyclic or heterocyclic ring optionally comprises additional substituents and the other pair forms an optionally substituted phenyl ring,
or R² and R¹ or R³ and R¹ form a 5- to 7-membered heterocyclic ring which can optionally comprise one or more substituents and which, in addition to the nitrogen atom it shares with the 1,4-dihydropyridine ring, optionally comprises additional nitrogen atoms, -NR¹³ groups,
-S- or -O-,
R¹³ is selected from a hydrogen atom, an alkyl group, aryl group and aralkyl group,
R⁶ is selected from an alkyl group optionally substituted with a halogen atom or a
-C(O) group, an optionally substituted aryl group, an optionally substituted aralkyl group, an optionally substituted heterocyclic group and the group 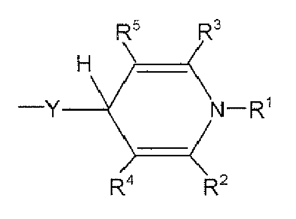
Y is an alkylene or arylene group,
R⁷ is a hydrogen atom, aryl group, aralkyl group or alkyl group, wherein the alkyl group and the alkyl unit of the aralkyl group optionally comprise one or more C-C double and/or C-C triple bonds,
and R⁸ and R⁹ are independently selected from a hydrogen atom, an optionally substituted alkyl group, an optionally substituted aryl group and an optionally substituted aralkyl group.

The sensitizers of formulas (V), (VI), (VII), and (VIII) are also suitable for UV sensitive elements. They are especially suitable for plates imaged by 30 µm (and lower) FM screening (FM = frequency-modulated): 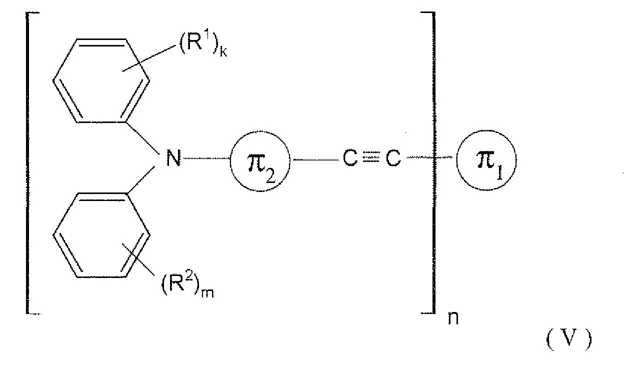 wherein
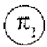 and each 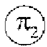 independently represent an aromatic or heteroaromatic unit,
each R¹ and R² is independently selected from a halogen atom, an alkyl, aryl or aralkyl group, a group -NR⁴R⁵ or a group -OR⁶,
R⁴, R⁵ and R⁶ are independently selected from an alkyl, aryl and aralkyl group and
n is an integer of at least 2 and
k and m independently represent 0 or an integer from 1 to 5;

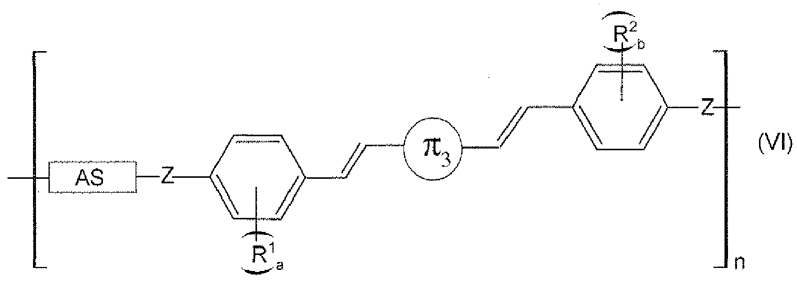

wherein 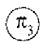 is an aromatic or heteroaromatic unit or a combination of the two so that a conjugated π-system is present between the two groups Z in structure (VI),
each Z independently represents a heteroatom connecting the spacer AS and the conjugated system,
each R¹ and R² is independently selected from a halogen atom, an alkyl, aryl, alkylaryl or aralkyl group, a group -NR³R⁴ and a group -OR⁵,
each R³, R⁴ and R⁵ is independently selected from an alkyl, aryl, alkylaryl and aralkyl group,
a and b independently represent 0 or an integer from 1 to 4,
n has a value of >1 and
AS is an aliphatic spacer,
described in more detail in DE 10 2004 055 733; 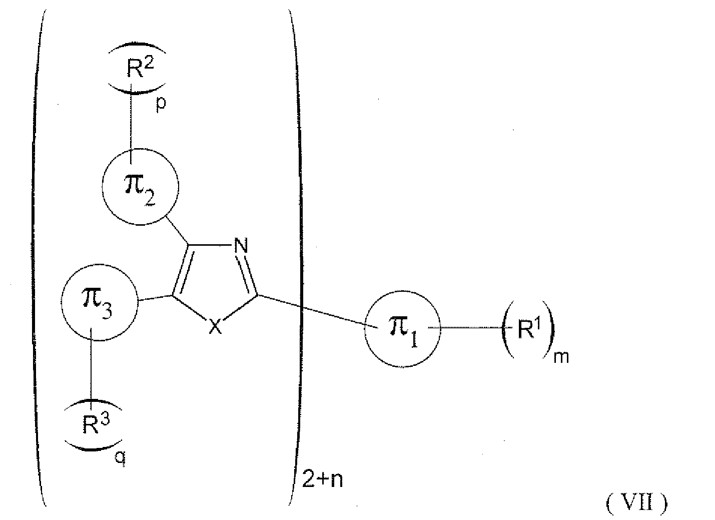 wherein
X is selected from O, S and Se;
n represents 0 or a positive integer;
m, p and q are independently 0 or a positive integer;
the π-units 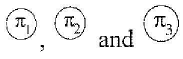 are independently unsaturated units, each with a conjugated π-electron system, which are covalently bonded to the heterocyclic unit 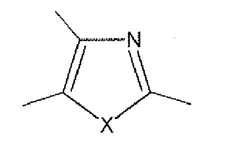 and together with this unit again form a conjugated π-electron system and
each group R¹, R² and R³ is independently selected from a hydrogen atom, a halogen atom, an alkyl group, an aralkyl group, a group -NR⁴R⁵ and a group -OR⁶,
wherein R⁴, R⁵ and R⁶ are independently selected from an alkyl group, aryl group and aralkyl group,
described in more detail in DE 10 2004 022 137 B3; 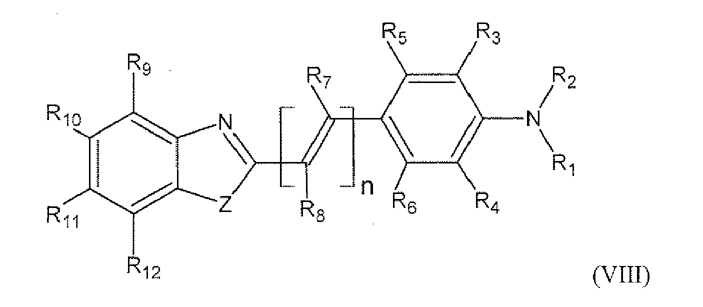
wherein
R₁ and R₂ are independently selected from the group consisting of hydrogen, unsubstituted and substituted aryl, unsubstituted and substituted heteroaryl and unsubstituted and substituted alkyl, said aryl or heteroaryl group being linked to R₃ or R₄ to form a 5- or 6-membered N-heteroaryl ring or not being linked to R₃ and R₄; provided that at least one of the groups R₁ and R₂ is an unsubstituted or substituted aryl or heteroaryl group;
or R₁ and R₂ together with the nitrogen atom to which they are attached form an N-heteroaryl group which either exhibits one or two fused benzene rings or does not exhibit any fused benzene rings;
R₃ and R₄ are independently selected from the group consisting of hydrogen, CN, halogen, unsubstituted and substituted alkyl, aralkyl, alkylaryl and aryl, -O-alkyl, -O-aryl, -S-alkyl, - COOR, -SOR, -SO₂R, -SO₃R, -NO₂, NR₂, NR₃⁺, and -PO₃R₂, wherein each R is selected from H, alkyl, aryl, aralkyl and alkylaryl, or R₃ or R₄ are linked to an aryl or heteroaryl group represented by R₁ or R₂ to form a 5- or 6-membered N-heteroaryl ring;
R₅ and R₆ are independently selected from the group consisting of hydrogen, CN, halogen, unsubstituted and substituted alkyl, aralkyl, alkylaryl and aryl, -O-alkyl, -O-aryl, -S-alkyl, - COOR, -SOR, -SO₂R, -SO₃R, -NO₂, NR₂, NR₃⁺ and -PO₃R₂ , wherein each R is selected from the group consisting of H, alkyl, aryl, aralkyl and alkylaryl, or, if R₃ and R₄ are not linked to R₁ and R₂, respectively, R₅ and R₃ and/or R₆ and R₄ form a 5- or 6-membered fused aromatic ring;
R₇ and R₈ are independently selected from the group consisting of hydrogen, CN, halogen, and unsubstituted and substituted alkyl, alkylaryl, aralkyl, and aryl;
n is selected from 0, 1 and 2;
Z represents O, S, Se or NR, wherein R is selected from the group consisting of hydrogen, alkyl, aryl, aralkyl and alkylaryl;
R₉ to R₁₂ are independently selected from the group consisting of hydrogen, halogen, CN, unsubstituted and substituted alkyl, aralkyl, alkylaryl and aryl, -O-alkyl, -O-aryl, -S-alkyl, - COOR, -SOR, -SO₂R, -SO₃R, -NO₂, NR₂, NR₃⁺, and -PO₃R₂ , wherein each R is selected from the group consisting of H, alkyl, aryl, aralkyl and alkylaryl,
provided that at least one of the groups R₉ to R₁₂ is a bulky group which has a van der Waals volume of at least 55 Å³; such sensitizers are disclosed in detail in WO 2007/090550.

Still another class of sensitizers useful for the UV range are those of formula (IX) 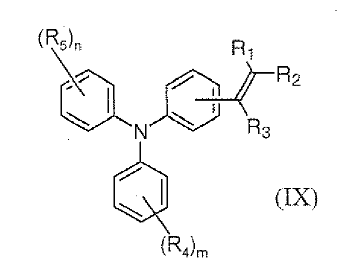 wherein
R₁ is an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₂ is selected from optionally substituted alkyl, aryl, aralkyl, alkylaryl, -N(alkyl)₂, -N(aryl)₂, - N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₃ is selected from hydrogen, optionally substituted alkyl, aryl, aralkyl, alkylaryl, -N(alkyl)₂, - N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₄ and R₅ are independently selected from -CR₃=CR₁R₂ with R₁, R₂ and R₃ being as defined above, optionally substituted alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -CH₂-O-R, -CH₂-S-R, -COOR and -CSOR;
if there are two adjacent substituents R₄ they can optionally form a fused aromatic or non-aromatic carbocyclic ring; the same applies to R₅;
each R is independently selected from optionally substituted alkyl, optionally substituted aryl, aralkyl and alkylaryl;
m and n are the same or different and are integers from 0 to 5;
these sensitizers are described in detail in EP 1 921 599 A1.

If the radiation-sensitive elements are to be exposed with VIS laser diodes, the cyanopyridone derivatives described in WO 03/069411 A1 are for example suitable as sensitizers.

For IR-sensitive elements, the sensitizers are for example selected from carbon black, phthalocyanine pigments/dyes and pigments/dyes of the polythiophene, squarylium, thiazolium, croconate, merocyanine, cyanine, indolizine, pyrylium or metaldithiolin classes, especially preferred from the cyanine class. The compounds mentioned in Table 1 of US 6,326,122 for example are suitable IR dyes. Further examples can be found in US 4,327,169, US 4,756,993, US 5,156,938, WO 00/29214, US 6,410,207 and EP 1 176 007 A1.

According to one embodiment, a cyanine dye of formula (X) 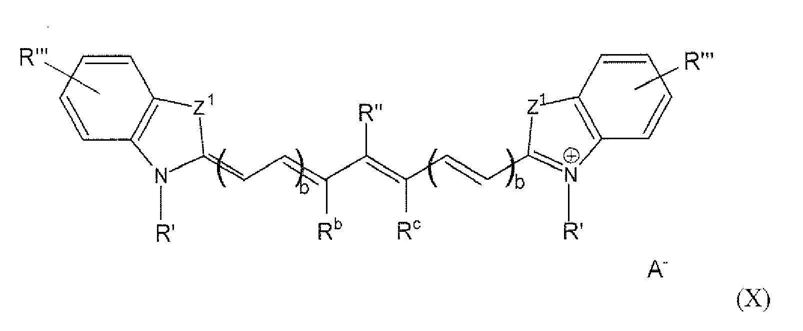 is used, wherein
each Z¹ independently represents S, O, NR^{a} or C(alkyl)₂;
each R' independently represents an alkyl group, an alkylsulfonate group or an alkylammonium group;
R" represents a halogen atom, SR^{a}, OR^{a}, SO₂R^{a} or NR^{a}₂;
each R"' independently represents a hydrogen atom, an alkyl group, -COOR^{a}, -OR^{a}, -SR^{a}, -NR^{a}₂ or a halogen atom; R"' can also be a benzofused ring;
A⁻ represents an anion;
R^{b} and R^{c} either both represent hydrogen atoms or, together with the carbon atoms to which they are attached, form a carbocyclic five- or six-membered ring;
R^{a} represents a hydrogen atom, an alkyl or aryl group;
each b is independently 0, 1, 2 or 3.

If R' represents an alkylsulfonate group, an internal salt can form so that no anion A⁻ is necessary. If R' represents an alkylammonium group, a second counterion is needed which is the same as or different from A⁻.

Of the IR dyes of formula (X), dyes with a symmetrical structure are especially preferred. Examples of especially preferred dyes include:
2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium tosylate,
2-[2-[2-chloro-3-[2-(1,3-dihydro-1,3,3-trimethyl-2H-benzo[e]-mdole-2-ylidene)-ethylidene]-1-cyclohexene-1-yl]-ethenyl]-1,3,3-trimethyl-1H-benzo[e]-indolium tosylate and
2-[2-[2-chloro-3-[2-ethyl-(3H-benzthiazole-2-ylidene)-ethylidene]-1-cyclohexene-1-yl]-ethenyl]-3-ethyl-benzthiazolium tosylate.

The following compounds are also IR dyes suitable for the present invention:

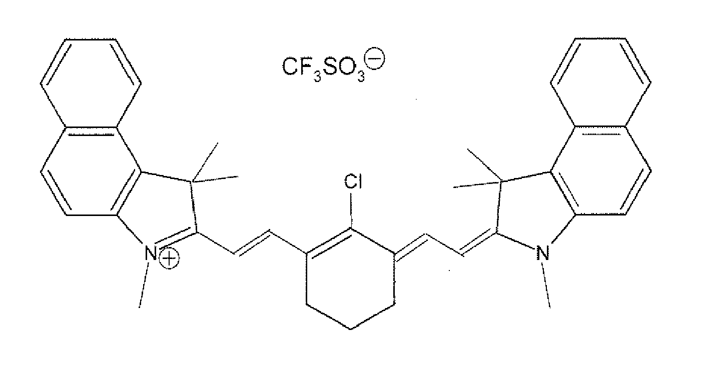

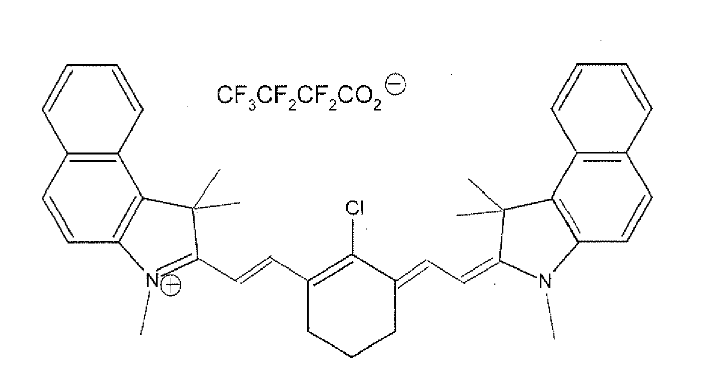

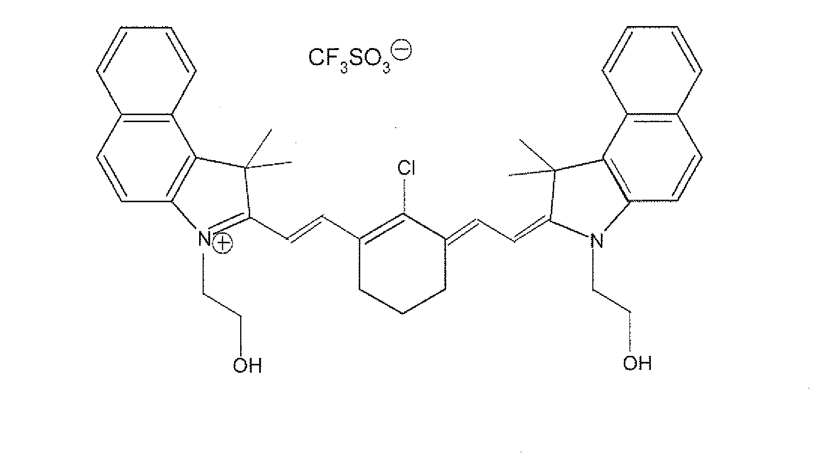

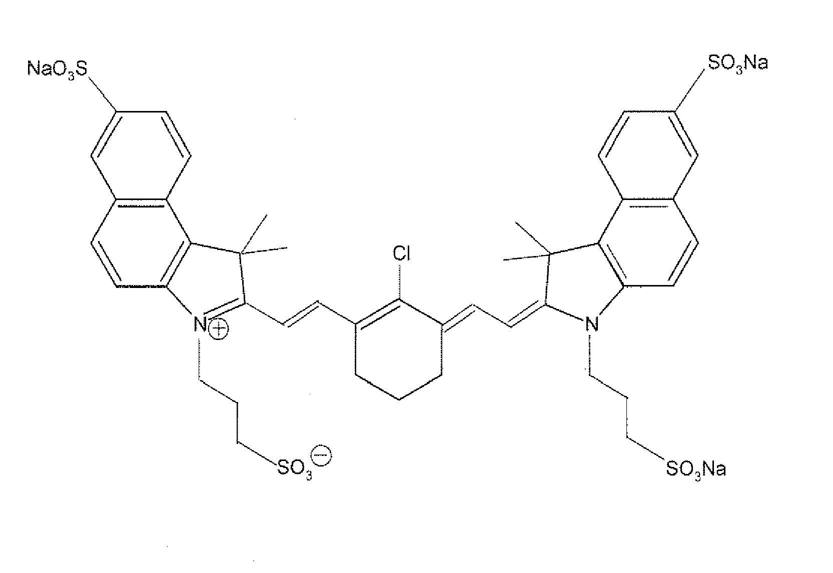

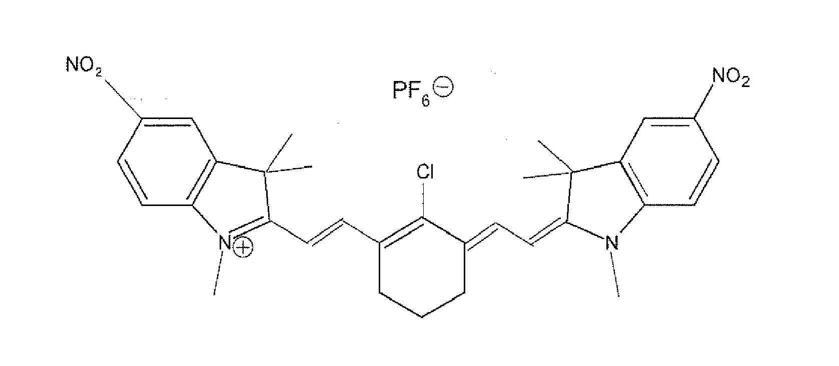

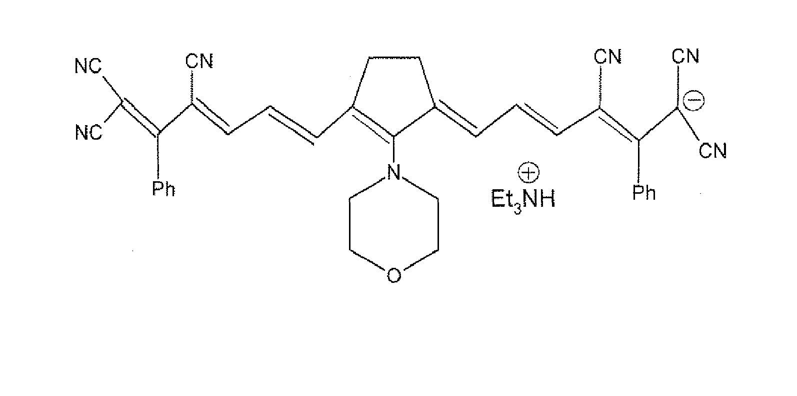

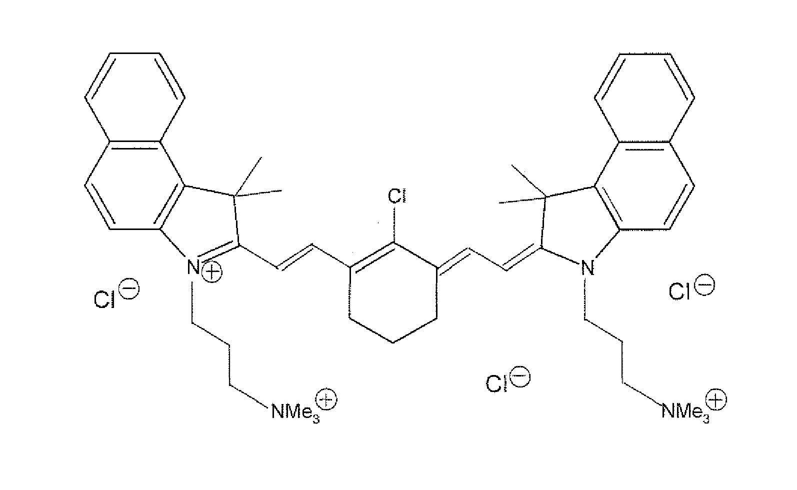

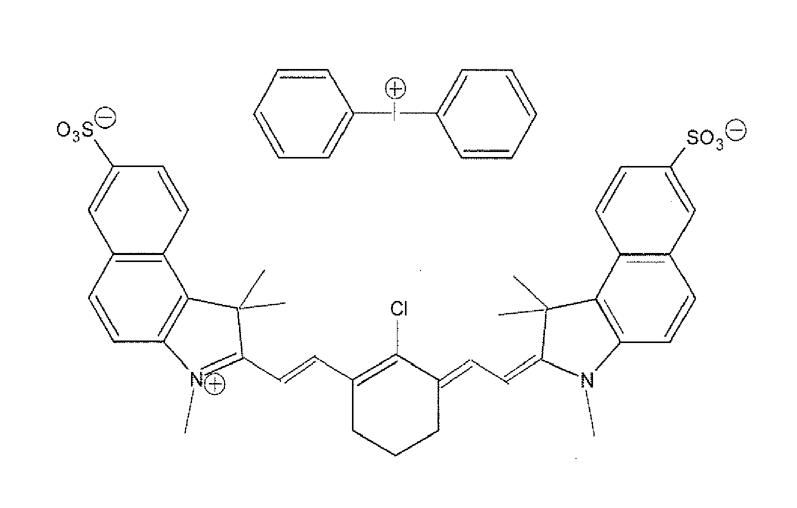

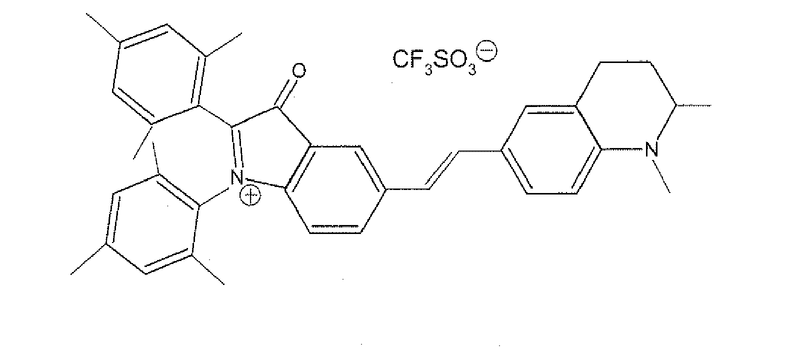

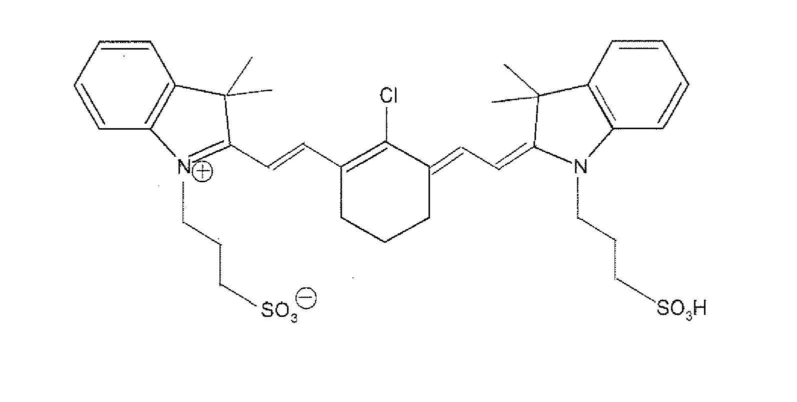

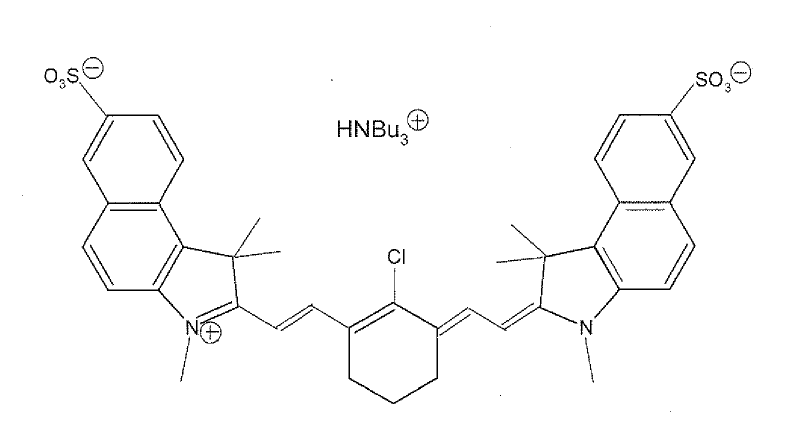

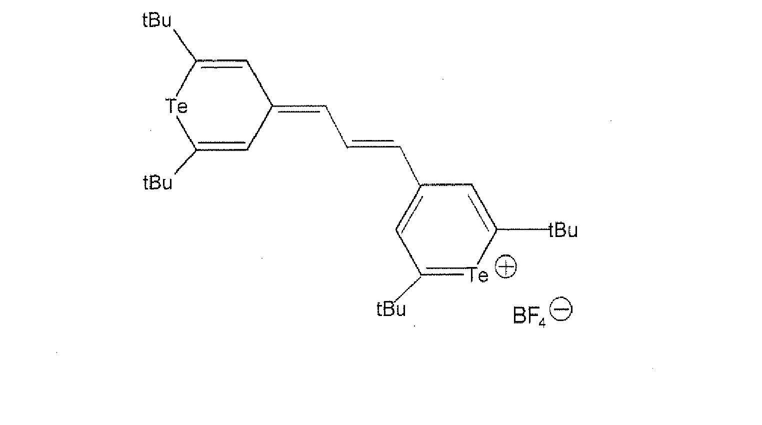

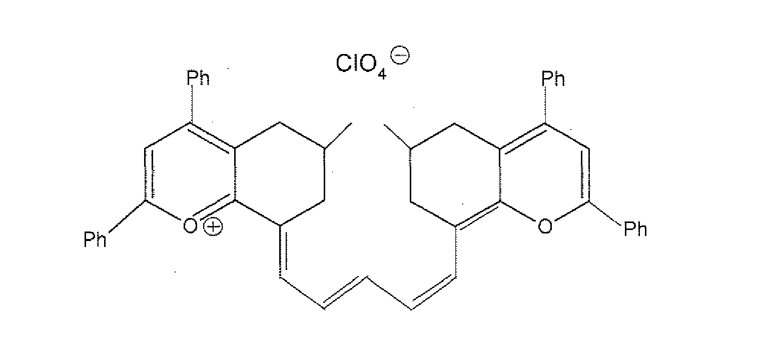

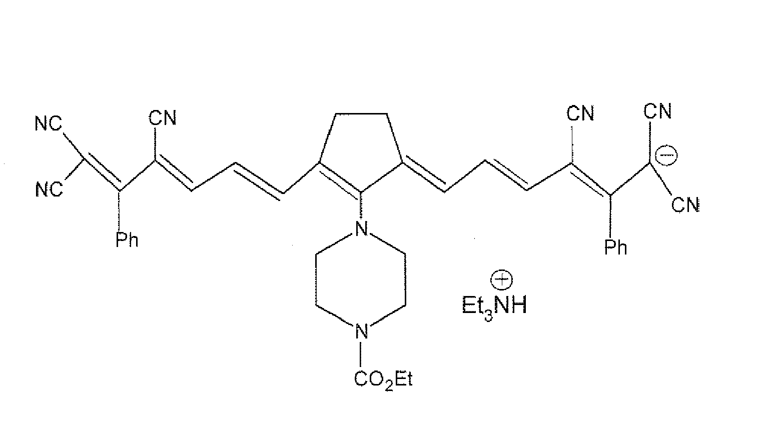

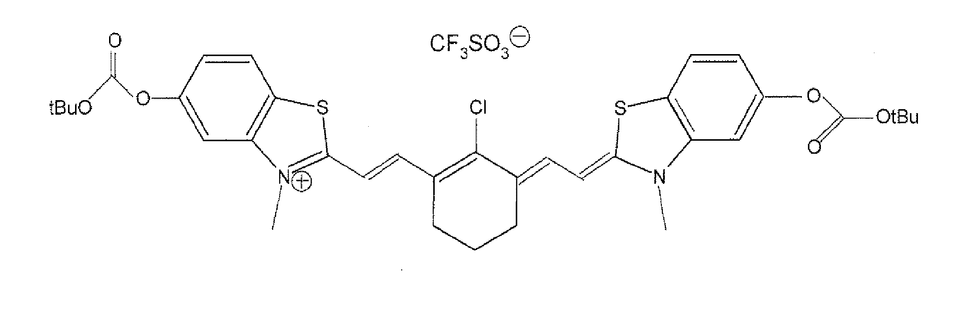

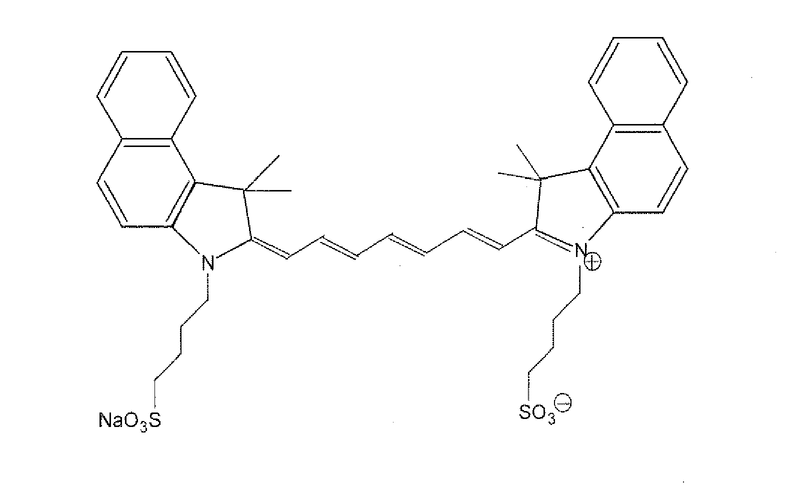

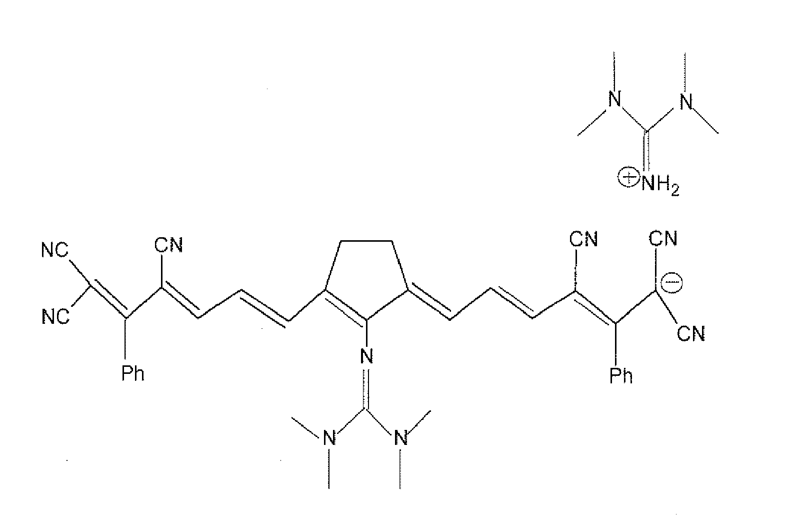

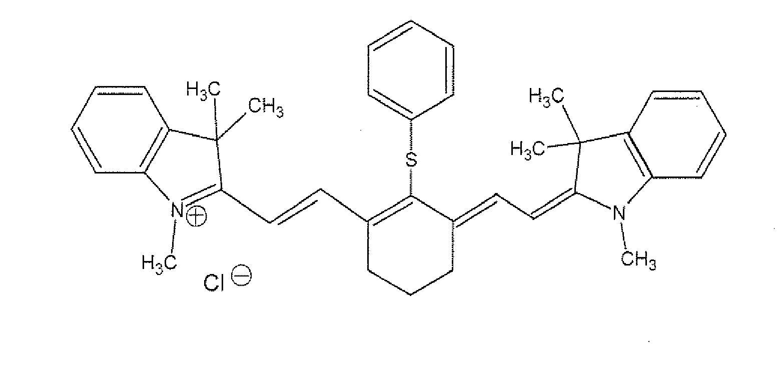

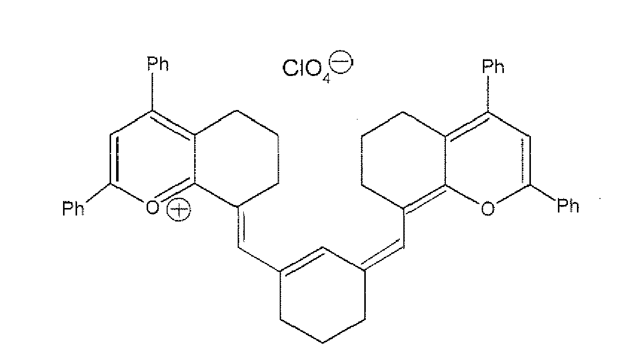

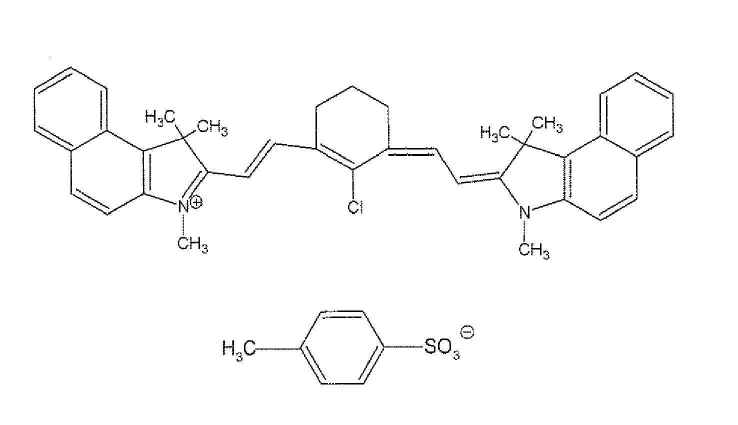

In the present invention, one sensitizer or a mixture of two or more can be used.

The sensitizers are used in combination with one or more coinitiators. Additionally, photoinitiators can be used; however, this is not preferred.

The amount of sensitizer(s) is not particularly restricted; however, if sensitizers are present, it is preferably in the range of 0.2 to 15 wt-%, based on the dry layer weight of the imageable coating, especially preferred 0.5 to 10 wt-%. If both photoinitiators and sensitizers are present in the coating, their total amount is preferably 0.5 to 30 wt-%, based on the dry layer weight, especially preferred 1 to 15 wt-%.

A coinitiator as referred to in the present invention is a compound that is essentially unable to absorb when irradiated but forms free radicals together with the radiation-absorbing sensitizers used in the present invention. The coinitiators are for example selected from onium compounds, for example those where the onium cation is selected from iodonium (such as e.g. diaryliodonium salts), sulfonium (such as triarylsulfonium salts), phosphonium, oxylsulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl or aryl; N-arylglycines and derivatives thereof (e.g. N-phenylglycine); aromatic sulfonyl halides; trihalomethylarylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US-A-5,629,354); hexaarylbiimidazoles; thiol compounds (e.g. mercaptobenzthiazole, mercaptobenzimidazole and mercaptotriazole); 1,3,5-triazine derivatives with 1 to 3 CX₃ groups (wherein every X is independently selected from a chlorine or bromine atom, and is preferably a chlorine atom), such as e.g. 2-phenyl-4,6-bis(trichloromethyl)-s-triazine, 2,4,6-tris(trichloromethyl)-s-triazine, 2-methyl-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; metallocenes (preferably titanocenes, and especially preferred those with two five-membered cyclodienyl groups, such as e.g. cyclopentadienyl groups and one or two six-membered aromatic groups with at least one ortho fluorine atom and optionally also a pyrryl group, such as bis(cyclopentadienyl)-bis-[2-6-difluoro-3-(pyrr-1-yl)-phenyl]titanium and dicyclopentadiene-bis-2,4,6-trifluorophenyl-titanium or zirconium); acylphosphine oxides, diacylphosphine oxides and peroxides (e.g. those listed in EP-A1-1 035 435 as activators of the type of an organic peroxide), α-hydroxy or α-amino acetophenones, acylphosphines, acylphosphinesulfides, carbonyl compounds such as aromatic ketones or quinones, e.g. benzophenone derivatives, Michler's ketone, thioxanthone derivatives, anthraquinone derivatives and fluorenone derivatives.

Suitable 2,2',4,4',5,5' -hexaarylbiimidazoles (in the following simply referred to as hexaarylbiimidazoles) are represented by the following formula (XI): 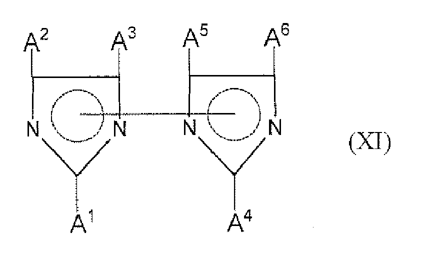 wherein A¹-A⁶ are substituted or unsubstituted C₅-C₂₀ aryl groups which are identical or different from each other and in whose rings one or more carbon atoms can optionally be substituted by heteroatoms selected from O, N and S. Suitable substituents for the aryl groups are those that do not inhibit the light-induced dissociation to triarylimidazolyl radicals, e.g. halogen atoms (fluorine, chlorine, bromine, iodine), -CN, C₁-C₆ alkyl (optionally with one or more substituents selected from halogen atoms, -CN and -OH), C₁-C₆ alkoxy, C₁-C₆ alkylthio, (C₁-C₆ alkyl) sulfonyl.

Preferred aryl groups are substituted and unsubstituted phenyl, biphenyl, naphthyl, pyridyl, furyl and thienyl groups. Especially preferred are substituted and unsubstituted phenyl groups, and particularly preferred are halogen-substituted phenyl groups.

Examples include:
2,2'-Bis(bromophenyl)-4,4',5,5'-tetraphenylbiimidazole,
2,2'-bis(p-carboxyphenyl)-4,4',5,5'-tetraphenylbiimidazole,
2,2'-bis(o-chlorophenyl)-4,4',5,5'-tetrakis(p-methoxyphenyl)biimidazole,
2,2'-bis(p-chlorophenyl)-4,4',5,5'-tetrakis(p-methoxyphenyl)biimidazole,
2,2'-bis(p-cyanophenyl)-4,4'5,5'-tetrakis(p-methoxyphenyl)biimidazole,
2,2'-bis(2,4-dichlorophenyl)-4,4',5,5'-tetraphenylbiimidazole,
2,2'-bis(2,4-dimethoxyphenyl)-4,4',5,5'-tetraphenylbiimidazole,
2,2'-bis(o-ethoxyphenyl)-4,4',5,5'-tetraphenylbiimidazole,
2,2'-bis(m-fluorophenyl)-4,4',5,5'-tetraphenylbiimidazole,
2,2'-bis(o-fluorophenyl)-4,4',5,5'-tetraphenylbiimidazole,
2,2'-bis(p-fluorophenyl)-4,4',5,5'-tetraphenylbiimidazole,
2,2'-bis(o-hexoxyphenyl)-4,4',5,5'-tetraphenylbiimidazole,
2,2'-bis(o-hexylphenyl)-4,4',5,5'-tetrakis(p-methoxyphenyl)biimidazole,
2,2'-bis(3,4-methylenedioxyphenyl)-4,4',5,5'-tetraphenylbiimidazole,
2,2'-bis(o-chlorophenyl)-4,4',5,5'-tetrakis(m-methoxyphenyl)biimidazole,
2,2'-bis(o-chlorophenyl)-4,4',5,5'-tetrakis[m-(betaphenoxy-ethoxyphenyl)]biimidazole,
2,2'-bis(2,6-dichlorophenyl)-4,4',5,5-tetraphenylbiimidazole,
2,2'-bis(o-methoxyphenyl)-4,4',5,5'-tetraphenylbiimidazole,
2,2'-bis(p-methoxyphenyl)-4,4'-bis(o-methoxyphenyl)-5,5'-diphenylbiimidazole,
2,2'-bis(o-nitrophenyl)-4,4',5,5'-tetraphenylbiimidazole,
2,2'-bis(p-phenylsulfonylphenyl)-4,4',5,5'-tetraphenylbiimidazole,
2,2'-bis(p-sulfamoylphenyl)-4,4',5,5'-tetraphenylbiimidazole,
2,2'-bis(2,4,5-trimethylphenyl)-4,4',5,5'-tetraphenylbiimidazole,
2,2'-di-4-biphenylyl-4,4',5,5'-tetraphenylbiimidazole,
2,2'-di-1-naphthyl-4,4',5,5'-tetrakis(p-methoxyphenyl)biimidazole,
2,2'-di-9-phenanthryl-4,4',5,5'-tetrakis(p-methoxyphenyl)biimidazole,
2,2'-diphenyl-4,4',5,5'-tetra-4-biphenylylbiimidazole,
2,2'-diphenyl-4,4',5,5'-tetra-2,4-xylylbiimidazole,
2,2'-di-3-pyridyl-4,4',5,5'-tetraphenylbiimidazole,
2,2'-di-3-thienyl-4,4',5,5'-tetraphenylbiimidazole,
2,2'-di-o-tolyl-4,4',5,5'-tetraphenylbiimidazole,
2,2'-di-p-tolyl-4,4'-di-o-tolyl-5,5'-diphenylbiimidazole,
2,2'-di-2,4-xylyl-4,4',5,5'-tetraphenylbiimidazole,
2,2',4,4',5,5'-hexakis(p-benylthiophenyl)biimidazole,
2,2',4,4',5,5'-hexa-1-naphthylbiimidazole,
2,2',4,4',5,5'-hexaphenylbiimidazole,
2,2'-bis(2-nitro-5-methoxyphenyl)-4,4',5,5'-tetraphenylbiimidazole,
2,2'-bis(o-nitrophenyl)-4,4',5,5'-tetrakis(m-methoxyphenyl)biimidazole, and
2,2'-bis(2-chloro-5-sulfophenyl)-4,4',5,5'-tetraphenylbiimidazole.

Suitable hexaarylbiimidazoles can be prepared according to known methods (see e.g. US-A-3,445,232). A preferred process is the oxidative dimerization of corresponding triarylimidazoles with iron-(III)-hexacyanoferrate (II) in an alkali solution.

The trihalogenmethyl compounds suitable as coinitiators are capable of forming free radicals. Trihalogenmethyl-substituted triazines and trihalogenmethyl-arylsulfones are preferred. The following can be mentioned as examples (without restricting the invention to these compounds):
2-(4-Methoxyphenyl)-4,6-bis(trichloromethyl)-s-triazine,
2-(4-chlorophenyl)-4,6-bis-(trichloromethyl)-s-triazine,
2-phenyl-4,6-bis(trichloromethyl)-s-triazine,
2,4,6-tris-(trichloromethyl)-s-triazine,
2,4,6-tris-(tribromomethyl)-s-triazine and
tribromomethylphenylsulfone.

Preferred coinitiators are onium compounds as described above and more preferred are iodonium compounds and especially preferred are diaryliodonium compounds represented by the following formula (XII): 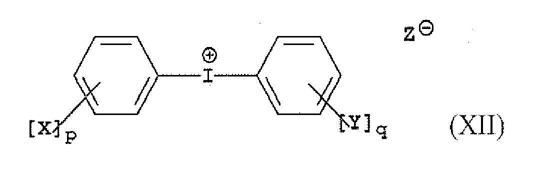 wherein X and Y are independently halo groups (for example, fluoro, chloro, or bromo), substituted or unsubstituted alkyl groups having 1 to 20 carbon atoms (for example, methyl, chloromethyl, ethyl, 2-methoxyethyl, *n*-propyl, *iso*propyl, *iso*butyl, *n*-butyl, *t*-butyl, all branched and linear pentyl groups, 1-ethylpentyl, 4-methylpentyl, all hexyl isomers, all octyl isomers, benzyl, 4-methoxybenzyl, *p*-methylbenzyl, all dodecyl isomers, all icosyl isomers, and substituted or unsubstituted mono-and poly-, branched and linear haloalkyls), substituted or unsubstituted alkyloxy having 1 to 20 carbon atoms (for example, substituted or unsubstituted methoxy, ethoxy, *iso*-propoxy, *t*-butoxy, (2-hydroxytetradecyl)oxy, and various other linear and branched alkyleneoxyalkoxy groups), substituted or unsubstituted aryl groups having 6 or 10 carbon atoms in the carbocyclic aromatic ring (such as substituted or unsubstituted phenyl and naphthyl groups including mono- and polyhalophenyl and naphthyl groups), or substituted or unsubstituted cycloalkyl groups having 3 to 8 carbon atoms in the ring structure (for example, substituted or unsubstituted cyclopropyl, cyclopentyl, cyclohexyl, 4-methylcyclohexyl, and cyclooctyl groups). For example, X and Y are independently substituted or unsubstituted alkyl groups having 1 to 8 carbon atoms, alkyloxy groups having 1 to 8 carbon atoms, or cycloalkyl groups having 5 or 6 carbon atoms in the ring, and more preferably, X and Y are independently substituted or unsubstituted alkyl groups having 3 to 6 carbon atoms (and particularly branched alkyl groups having 3 to 6 carbon atoms). Thus, X and Y can be the same or different groups, the various X groups can be the same or different groups, and the various Y groups can be the same or different groups. Both "symmetric" and "asymmetric" diaryliodonium compounds are contemplated by this invention but the "symmetric" compounds are preferred (that is, they have the same groups on both phenyl rings).

In addition, two or more adjacent X or Y groups can be combined to form a fused carbocyclic or heterocyclic ring with the respective phenyl groups.
The X and Y groups can be in any position on the phenyl rings but preferably they are at the 2-or 4-positions, and more preferably at the 4-position, on either or both phenyl rings.
In formula (XII), p and q are independently 0 or integers of 1 to 5. For example, both p and q can be 1. Thus, it is understood that the carbon atoms in the phenyl rings that are not substituted by X or Y groups have a hydrogen atom at those ring positions.

Z- is an inorganic or organic anion and preferably an organic borate anion represented by the following formula (XIII): 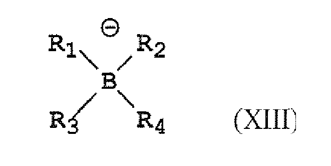 wherein R₁, R₂, R₃, and R₄ are independently substituted or unsubstituted alkyl, aryl, alkenyl, alkynyl, cycloalkyl or heterocyclyl groups, or two or more of R₁, R₂, R₃ and R₄ together form a 5-7 membered heterocyclic ring with a boron atom and optionally one or more further hetero ring atoms selected from nitrogen and oxygen. Preferably R₁, R₂, R₃ and R₄ are independently selected from substituted or unsubstituted alkyl groups having 1 to 12 carbon atoms (such as methyl, ethyl, *n*-propyl, *iso*-propyl, *n*-butyl, *iso*butyl, *t*-butyl, all pentyl isomers, 2-methylpentyl, all hexyl isomers, 2-ethylhexyl, all octyl isomers, 2,4,4-trimethylpentyl, all nonyl isomers, all decyl isomers, all undecyl isomers, all dodecyl isomers, methoxymethyl, and benzyl) other than fluoroalkyl groups, substituted or unsubstituted carbocyclic aryl groups having 6 to 10 carbon atoms in the aromatic ring (such as phenyl, *p*-methylphenyl, 2,4-methoxyphenyl, naphthyl, and pentafluorophenyl groups), substituted or unsubstituted alkenyl groups having 2 to 12 carbon atoms (such as ethenyl, 2-methylethenyl, allyl, vinylbenzyl, acryloyl, and crotonotyl groups), substituted or unsubstituted alkynyl groups having 2 to 12 carbon atoms (such as ethynyl, 2-methylethynyl, and 2,3-propynyl groups), substituted or unsubstituted cycloalkyl groups having 3 to 8 carbon atoms in the ring structure (such as cyclopropyl, cyclopentyl, cyclohexyl, 4-methylcyclohexyl, and cyclooctyl groups), or substituted or unsubstituted heterocyclyl groups having 5 to 10 carbon, oxygen, sulfur, and nitrogen atoms (including both aromatic and non-aromatic groups, such as substituted or unsubstituted pyridyl, pyrimidyl, furanyl, pyrrolyl, imidazolyl, triazolyl, tetrazoylyl, indolyl, quinolinyl, oxadiazolyl, and benzoxazolyl groups); alternatively, two or more of R₁, R₂, R₃, and R₄ can be joined together to form a heterocyclic ring with the boron atom, such rings having up to 7 carbon, nitrogen, oxygen, or nitrogen atoms.

For example, R₁, R₂, R₃, and R₄ are independently substituted or unsubstituted alkyl or aryl groups as defined above, or at least 3 of R₁, R₂, R₃, and R₄ are the same or different substituted or unsubstituted aryl groups (such as substituted or unsubstituted phenyl groups). In some embodiments, all of R₁, R₂, R₃, and R₄ are the same or different substituted or unsubstituted aryl groups or, all of the groups are the same substituted or unsubstituted phenyl group. For example, Z⁻ is a tetraphenyl borate wherein the phenyl groups are substituted or unsubstituted.

Representative iodonium borate compounds include but are not limited to, 4-octyloxyphenyl phenyliodonium tetraphenylborate, [4-[(2-hydroxytetradecyl)-oxylphenyl]phenyliodonium tetraphenylborate, *bis*(4-*t*-butylphenyl)iodonium tetraphenylborate, 4-methylphenyl-4'-hexylphenyliodonium tetraphenylborate, 4-methylphenyl-4'-cyclohexylphenyliodonium tetraphenylborate, bis(*t*-butylphenyl)iodonium tetrakis(pentafluorophenyl)borate, 4-hexylphenylphenyliodonium tetraphenylborate, 4-methylphenyl-4'-cyclohexylphenyliodonium *n*-butyltriphenylborate, 4-cyclohexylphenyl-phenyliodonium tetraphenylborate, 2-methyl-4-*t-*butylphenyl-4'-methylphenyliodonium tetraphenylborate, 4-methylphenyl-4'-pentylphenyliodonium tetrakis[3,5-bis(trifluoromethyl)phenyl]-borate, 4-methoxyphenyl-4'-cyclohexylphenyliodonium tetrakis(penta-fluorophenyl)borate, 4-methylphenyl-4'-dodecylphenyliodonium tetrakis(4-fluorophenyl)borate, bis(dodecylphenyl)iodonium tetrakis(pentafluorophenyl)-borate, and bis(4-*t*-butylphenyl)iodonium tetrakis(1-imidazolyl)borate. Useful compounds include bis(4-*t*-butylphenyl)iodonium tetraphenylborate, 4-methylphenyl-4'-hexylphenyliodonium tetraphenylborate, 2-methyl-4-*t*-butylphenyl-4'-methylphenyliodonium tetraphenylborate, and 4-methylphenyl-4'-cyclohexylphenyliodonium tetraphenylborate.

Many coinitiators can also function as photoinitiators when they are exposed in their absorption band. This way, photosensitive layers can be obtained that are e.g. sensitive over a wide spectral range because a photoinitiator or sensitizer covers the long-wavelength spectral range (IR and/or visible range) and a coinitiator covers the short-wavelength spectral range (e.g. the UV range). This effect can be advantageous if the consumer wants to irradiate the same material with different radiation sources. In this case, the coinitiator functions as an actual coinitiator in the sense of the definition given above for the IR or visible range, while it functions as a photoinitiator for the UV range.

In the present invention, one coinitiator or a mixture of coinitiators can be used.

The amount of coinitiator(s) is not particularly restricted; however, it is preferably in the range of 0.2 to 25 wt-%, based on the dry layer weight of the imageable coating, especially preferred 0.5 to 15 wt-%.

Further examples of suitable sensitizers and coinitiators for IR-sensitive coatings are also mentioned in WO 2004/041544, WO 2000/48836 and DE 10 2004 003143.

### Free-radical polymerizable component

All monomers or oligomers which comprise at least one C-C double bond can be used as free-radical polymerizable monomers or oligomers. Monomers/oligomers with C-C triple bonds can also be used, but they are not preferred. Suitable compounds are well known to the person skilled in the art and can be used in the present invention without any particular limitations. Esters of acrylic and methacrylic acids, itaconic acid, crotonic and isocrotonic acid, maleic acid and fumaric acid with one or more unsaturated groups in the form of monomers, oligomers or prepolymers are preferred. They may be present in solid or liquid form, with solid and highly viscous forms being preferred. Compounds suitable as monomers include for instance trimethylol propane triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, ditrimethylol propane tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins. According to the present invention the free-radical polymerizable component is a compound with low molecular weight, i.e. a molecular weight of preferably below 3000.

Another class of free-radical polymerizable components are compounds that have a molecular weight of 3,000 or less and are reaction products obtained by reacting a diisocyanate with (i) an ethylenically unsaturated compound with one hydroxy group, and at the same time (ii) a saturated organic compound with one NH group and one OH group, wherein the reactants are used in amounts according to the following condition:

Number of moles of isocyanate groups ≤ number of moles of OH plus NH groups.

Examples of diisocyanates are represented by the following formula:

O = C = N -(CR⁹₂)ₐ- D -(CR⁹₂)_{b}- N = C = O

wherein a and b independently represent 0 or an integer from 1 to 3, each R⁹ is independently selected from H and C₁-C₃ alkyl and D is a saturated or unsaturated spacer which can optionally comprise further substituents in addition to the two isocyanate groups. D can be a chain-shaped or a ring-shaped unit. As used in the present invention, the term "diisocyanate" refers to an organic compound comprising two isocyanate groups but no OH groups and no secondary and primary amino groups.

D can for example be an alkylene group (CH₂)_{w}, wherein w is an integer from 1 to 12, preferably 1 to 6, and one or more hydrogen atoms are optionally replaced with substituents such as e.g. alkyl groups (preferably C₁-C₆), a cycloalkylene group, an arylene group or a saturated or unsaturated heterocyclic group.

The ethylenically unsaturated compound (i), which comprises a hydroxy group, comprises at least one non-aromatic C-C double bond, which is preferably terminal. The hydroxy group is preferably not bonded to a doubly bonded carbon atom; the hydroxy group is not part of a carboxy group. In addition to the one OH group, the ethylenically unsaturated compound (i) does not comprise any further functional groups, such as e.g. NH, which can react with the isocyanate.

### Examples of the ethylenically unsaturated compound (i) include

Hydroxy(C₁-C₁₂)alkyl(meth)acrylates (e.g. 2-hydroxyethyl(meth)acrylate, 2- or 3-hydroxypropyl(meth)acrylate, 2-, 3- or 4-hydroxybutyl(meth)acrylate), hydroxy(C₁-C₁₂)alkyl(meth)acrylamides (e.g. 2-hydroxyethyl(meth)acrylamide, 2- or 3-hydroxypropyl(meth)acrylamide, 2-, 3- or 4-hydroxybutyl(meth)acrylamide), mono(meth)acrylates of oligomeric or polymeric ethylene glycols or propylene glycols (e.g. polyethylene glycol mono(meth)acrylate, triethylene glycol mono(meth)acrylate), allyl alcohol, pentaerythritol tri(meth)acrylate, 4-hydroxy(C₁-C₁₂)alkyl-styrene (e.g. 4-hydroxymethylstyrene), 4-hydroxystyrene, hydroxycyclohexyl(meth)acrylate.

The term "(meth)acrylate" as used in the present invention indicates that both methacrylate and acrylate etc. are meant.

The saturated organic compound (ii) is a compound with one OH and one NH group.

The saturated organic compound (ii) can for example be represented by the following formula (XIV) or (XV) 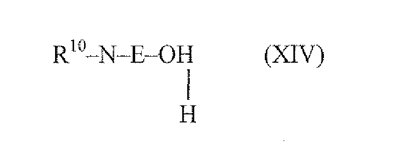 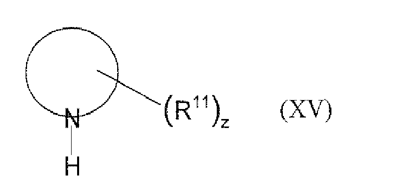
wherein R¹⁰ is a straight-chain (preferably C₁-C₁₂, especially preferred C₁-C₄), branched (preferably C₃-C₁₂, especially preferred C₃-C₆) or cyclic (preferably C₃-C₈, especially preferred C₅-C₆) alkyl group,
E is a straight-chain (preferably C₁-C₆, especially preferred C₁-C₂), branched (preferably C₃-C₁₂, especially preferred C₃-C₆) or cyclic (preferably C₃-C₈, especially preferred C₅-C₆) alkylene group, 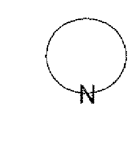 represents a saturated heterocyclic ring with 5 to 7 ring atoms, which in addition to the nitrogen atom shown above optionally comprises another heteroaton selected from S, O and
NR¹², wherein R¹² is an alkyl group optionally substituted with an OH group,
R¹¹ is OH or a straight-chain, branched or cyclic alkyl group substituted with an OH group, and
z = 0 if the heterocyclic ring comprises NR¹² and R¹² is an alkyl group substituted with OH and
z = 1 if the saturated heterocyclic ring does not comprise NR¹² or if the saturated heterocyclic ring comprises NR¹² and R¹² is an unsubstituted alkyl, group.

The number of moles of isocyanate groups must not exceed the number of moles of OH groups and NH groups combined since the product should not comprise any more free isocyanate groups.

Additional suitable C-C unsaturated free-radical polymerizable compounds are described e.g. in EP 1 176 007 A2.

It is of course possible to use different kinds of monomers, oligomers or polymers in the mixture; furthermore, mixtures of monomers and oligomers and/or polymers can be used in the present invention, as well as mixtures of oligomers and polymers.

The free-radical polymerizable component is preferably used in an amount of 5 to 95 wt-%, based on the dry layer weight of the imageable coating, especially preferred 10 to 85 wt-%.

### Reactive Blinder

According to the present invention the imageable coating comprises at least one reactive polymeric binder comprising repeating units A, B, and optionally C,

-(A)ₓ-, -(B)_{y}-, -(C)ₜ-,

wherein x is 5 to 30 mol%
y is 40 to 85 mol%
t is 0 to 60 mol%

A is at least one repeating unit comprising at least one pendant acid group; the acid group is preferably selected from -COOH, -SO₃H, -PO₂H₂ and -PO₃H₂, more preferably -COOH. Within the present invention the term "acid group" is meant to refer to free acid groups as well as salts thereof like alkali metal salts and ammonium salts thereof.

The pendant acid group can be directly linked to the backbone of the polymeric binder or it is bonded to the polymer backbone via a spacer like a alkyleneoxy, poly(alkylene oxid) chain, alkylene and arylene.

Suitable monomers which upon polymerization result in repeating units A are for example acrylic acid, methacrylic acid, itaconic acid, crotonic acid, maleic acid anhydride ring opened with C₁ to C₆ alcohols (which might be further substituted), vinyl benzoic acid, vinylphosphonic acid, vinylsulfonic acid, vinylbenzenesulfonic acid as well as salts thereof; preferred are acrylic acid and methacrylic acid and salts thereof.

A preferred group of repeating units A are those comprising not only a pendant acid group but also a pendant non-aromatic C-C double bond which is not an integral part of a bi- or polycyclic structure like a vinyl group -CH=CH₂ or an allyl group -CH₂-CH=CH₂. A suitable monomer which upon polymerization results in such preferred repeating units A is mono-2-((meth)acryloyloxy)ethyl maleat.

In the reactive polymeric binder one or more kinds of repeating units A can be present.

Repeating units A are present in the reactive polymeric binder in an amount of 5 to 30 mol%, preferably 10 to 25 mol%, more preferably 18.5 to 22.5 mol%.

B is a repeating unit comprising at least one pendant ethylenically unsaturated group which is an integral part of a bi- or polycyclic structure. By the expression "integral part" it is meant that the C-C double bond is not a pendant vinyl or allyl group but the double bond is part of the bi- or polycyclic structure. The term "bi- or polycyclic structure" refers to cyclic structures comprising structures with 2 or more rings fused to each other, bridged ring systems and spiranes but does not comprise polynuclear compounds where rings are connected to each other via single or double bonds.

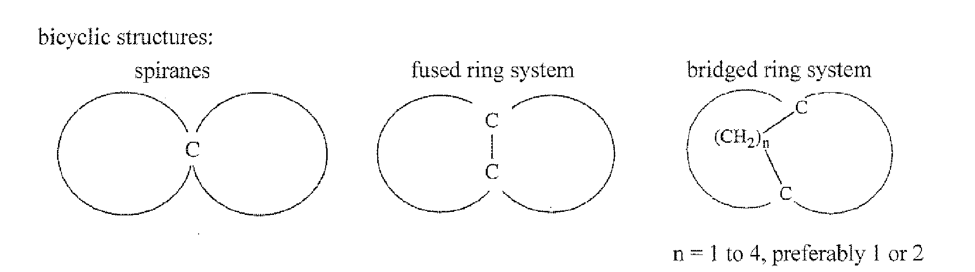

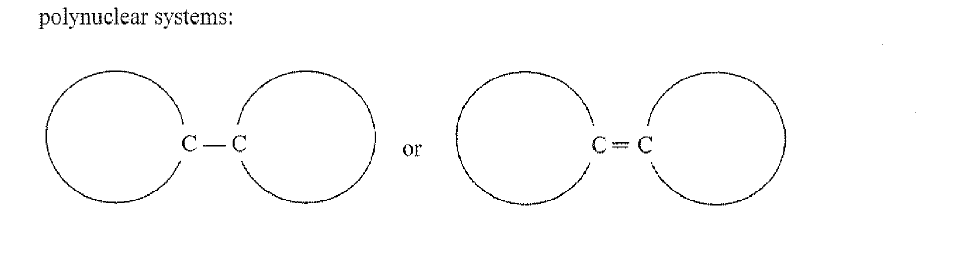

The bi- or polycyclic structure contains at least one 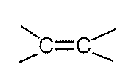 moiety as integral part of the ring system wherein the C-C double bond is not part of an aromatic ring. In addition to the non-aromatic C-C double bond ("ethylenically unsaturated group") the bi- or polycyclic structure can contain one or more aromatic rings either in fused form or as substituent.

The bi- or polycyclic structure can comprise one or more substituents selected from alkyl, alkoxy, aryl, halogen. Further, the bi- or polycyclic structure can comprise one or more heteroatoms such as N, S or O in the rings.

Each ring of the bi- or polycyclic structure can be independently selected from 5 to 7 membered rings, preferably 5 or 6 membered rings.

Preferred are optionally substituted fused ring systems and bridged ring systems and especially preferred are bridged ring systems.

At least one of the rings is not an aromatic ring and contains at least one C-C double bond which is not part of an aromatic system.

Preferred pendant bi- or polycyclic structures comprising at least one ethylenically unsaturated C-C bond are dicyclopentadienyl moieties, dicyclopentenyl moieties, norbornene moietes, norbornadiene moieties, dicyclohexenyl moieties and the like.

The bi- or polycyclic structure can be directly linked to the polymer backbone or can be bonded to the polymer backbone via a spacer like a poly(alkylene oxide) chain.

Suitable monomers which upon polymerization result in repeating units B are for example ethylene glycol dicyclopentenyl (meth)acrylate, dicyclopentenyl ether (meth)acrylate, ethylene glycol norbornenyl (meth)acrylate and norbornenyl (meth)acrylate.

In the reactive polymeric binder one or more kinds of repeating units B can be present.

Repeating units B are resent in the reactive polymeric binder in an amount of 40 to 85 mol%, preferably 45 to 75 mol%, more preferably 50 to 60 mol%.

Repeating unit C is a repeating unit derived from a (meth)acrylic acid ester or a (meth)acrylamide. Suitable (meth)acrylates are for instance C₁-C₄ alkyl esters, C₃-C₈ cycloalkyl ester, aryl esters, and esters of a polyalkylene glycol, or an alkylene glycol, wherein the alkyl, cycloalkyl and aryl moieties can be optionally substituted with one or more (for instance 1 or 2) substituents selected from OH, SH and NR¹R² (wherein R¹ and R² are independently selected from H and alkyl (preferably C₁-C₄)).

Suitable (meth)acrylamides are represented by the following formula 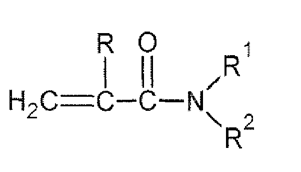 wherein R is H or CH₃; and R¹ and R² are independently selected from H, alkyl (preferably C₁-C₄) and alkenyl (preferably C₁-C₄).

Preferably, unit C is derived from ethylene glycol (meth)acrylate, propylene glycol (meth)acrylate, poly(ethylene glycol) (meth)acrylate, poly(propylene glycol) (meth)acrylate, 2-aminoethyl (meth)acrylate, 2-(N-alkyl)aminoethyl (meth)acrylate, 2-(N,N-dialkyl)aminoethyl 1 (meth)acrylate, benzyl(meth)acrylate, cyclohexyl(meth)acrylate, isobornyl(meth)acrylate, allyl(meth)acrylate, or N-allyl(meth)acrylamide.

In the reactive polymeric binder one ore more kinds of repeating units C can be present (if present at all).

Repeating units C are present in the reactive polymeric binder in an amount of 0 to 60 mol%, preferably 1 to 50 mol%, more preferably 5 to 30 mol%.

It is preferred that the content of all repeating units comprising in the side chain an ethylenically unsaturated bond (including units B) is at least 40 mol%, more preferred at least 50 mol%; preferably said content does not exceed 95 mol%, more preferably it does not exceed 75 mol%.

In the present invention one reactive binder as described above or a mixture of 2 or more thereof can be used.

The amount of the above described reactive binder(s) is not particularly restricted; however, it is preferably in the range of 25 to 55 wt% based on the dry layer weight of the imageable coating, especially preferred 35 to 45 wt%.

Preferably, the reactive binder has an acid value of at least 10 mg KOH/g polymer more preferably 30 to 100 mg KOH/g polymer.

### Further Benders

Suitable optional non-reactive binders are polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of non-reactive binders is preferably 0 to 30 wt%, based on the dry layer weight of the imageable coating, especially preferred 15 to 25 wt%.

Further suitable optional binders are "reactive binders", (i.e. polymeric binders having side chains comprising free radical polymerizable groups) other than those defined above which comprise a bi- or polycyclic structure. For example the reactive side groups are selected from acryl, methacryl, styryl, allyl, and mixtures of two or more thereof. The polymer backbone is not limited and is for example selected from an acrylic backbone, methacrylic backbone, acetal backbone, urethane backbone, and styrene backbone; copolymers of the aforementioned are also possible. Suitable reactive binders are disclosed in a number of patent applications e.g. WO 2004/014652 A1, WO 89/06659 A1, DE 29 03 270 A1, WO 95/12147, EP 410 242, and US 4,035,321.

The total amount of reactive binders other than the essential reactive binders comprising a bi- or polycyclic structure is preferably 0 to 30 wt-%, based on the dry layer weight of the imageable coating, especially preferred 15 to 25 wt-%.

The total amount of reactive and non-reactive binders present in addition to the reactive binders comprising a bi- or polycyclic structure is preferably 0 to 30 wt%, based on the dry layer weight of the imageable coating, especially preferred 15 to 25 wt%.

### Further optional components

Independently of whether the element is UV/VIS- or IR-sensitive, the radiation-sensitive coating can comprise one or more of the following optional components in addition to the essential components. If the coating consists of several layers, the optional component(s) can be present in one, several or all of the layers. Dyes or pigments having a high absorption in the visible spectral range can be present in order to increase the contrast ("contrast dyes and pigments"). Particularly suitable dyes and pigments are those that dissolve well in the solvent or solvent mixture used for coating or are easily introduced in the disperse form of a pigment. Suitable contrast dyes include *inter alia* rhodamine dyes, triarylmethane dyes such as Victoria blue R and Victoria blue BO, crystal violet and methyl violet, anthraquinone pigments, azo pigments and phthalocyanine dyes and/or pigments. The colorants are preferably present in an amount of 0 to 15 wt-%, more preferred 0.5 to 10 wt-%, particularly preferred 1.5 to 7 wt-%, based on the dry layer weight.

Furthermore, the layer can comprise surfactants (e.g. anionic, cationic, amphoteric or non-ionic surfactants or mixtures thereof). Suitable examples include fluorine-containing polymers, polymers with ethylene oxide and/or propylene oxide groups, sorbitol-tri-stearate and alkyl-di-(aminoethyl)-glycines. They are preferably present in an amount of 0 to 10 wt-%, based on the dry layer weight, especially preferred 0.2 to 5 wt-%.

The layer can furthermore comprise print-out dyes such as crystal violet lactone or photochromic dyes (e.g. spiropyrans etc.). They are preferably present in an amount of 0 to 15 wt-%, based on the dry layer weight, especially preferred 0.5 to 5 wt-%.

Also, flow improvers can be present in the layer(s), such as poly(glycol)ether-modified siloxanes; they are preferably present in an amount of 0 to 1 wt-%, based on the dry layer weight.

The layer(s) can furthermore comprise antioxidants such as e.g. mercapto compounds (2-mercaptobenzimidazole, 2-mereaptobenzthiazole, 2-mercaptobenzoxazole and 3-mercapto-1,2,4-triazole), and triphenylphosphate. They are preferably used in an amount of 0 to 15 wt-%, based on the dry layer weight, especially preferred 0.5 to 5 wt-%.
The layer(s) can furthermore comprise anaerobic or aerobic radical polymerization inhibitors.
The anaerobic free radical inhibitors function best in the absence of oxygen because they are able to react directly with the free radicals. Useful compounds of this type include nitroso compounds (broth N- and C-nitroso), N-oxides, and hydroxylamine derivatives. Typical examples include but are not limited to:
C-nitroso compounds such as C₄ to C₁₀ nitroso alkanes (for example, *t*-nitrosobutane and *t*-nitrosoctane), aromatic C-nitroso compounds (for example, nitrosobenzene, 2-nitrosotoluene, nitrosodurene, 4-nitrosophenol, 1-nitroso-2-naphthole, 2-nitroso-1-naphthole, 4-nitrosodiphenylamine, 3,5-dibromo-4-nitrosobenzenesulfonic acid or salt, and 2-methyl-2-nitrosopropane dimer);
N-nitroso-compounds such as N-nitroso-N-phenyl hydroxylamine and their complexes with cations ([PhN(NO)O]ₘM1 wherein M1 is ammonium ion, or metal ions of the 3rd-6th period elements of the Groups I-VIII of the Periodic Table, and m is 1 to 4), N-nitrosodiphenylamine, N-nitrosopyrrolidine, N-*t*-butyl-N-nitrosoaniline, N-nitrosodimethylamine, N-nitrosodiethylamine, 1-(aminocarbonyl)-1-methyl-2-oxohydrazine, 1-nitrosopiperidine, 4-nitrosomorpholine, N-nitroso-N-methylbutylamine, N-nitroso-N-ethylurea, and N-nitrosohexamethyleneimine;
N-oxides such as 5,5-dimethyl-1-pyrroline N-oxide, α-(4-pyridyl N-oxide)-N-*t*-butylnitrone, N-*t*-butyl-α-phenylnitrone, and 3,3,5,5-tetramethyl-1-pyrroline N-oxide;
hydroxylamine derivatives such as 1-hydroxy-2,2,6,6-tetramethyl-4-piperidone.

The N-nitroso compounds are particularly useful, including N-nitroso-N-phenyl hydroxylamine and their aluminum or sodium complexes.

The aerobic free radical inhibitors can function as an inhibitor in a free radical polymerizable composition only in the presence of oxygen. These inhibitors have a low inhibiting efficiency in the absence of oxygen. Typical representatives of aerobic free radical inhibitors include phenolic compounds such as phenols including sterically hindered phenols. Examples include but are not limited to, hydroquinone, 4-methoxyphenol (MEHQ), 2,6-di-tert-butyl-4-methylphenol (BHT), 4,4'-bis(2,6-di-tert-butylphenol), 1,3,5-trimethyl-2,4,6-tris(3,5-di-tert-butyl-4-hydroxybenzyl)-benzene, and 3,5-di-tert-butyl-1,2-benzenediol. In the case of phenolic aerobic free radical inhibitors, the low efficiency of inhibiting the radical polymerization can be explained by the lack of reaction of polymer radicals with the inhibitor but by the fast reaction of the phenols with peroxy radicals formed by reaction of polymer radicals with oxygen. When radiation-sensitive compositions are stabilized by only aerobic free radical inhibitors, a certain level of oxygen concentration is needed to guarantee the required shelf life of the composition or imageable element. Thus, in the case of lithographic printing plate precursors that have an oxygen barrier topcoat layer, the permeability of the topcoat layer should be not too low resulting in a limited stability of the latent image formed after exposure. Radiation-sensitive compositions with high latent image keeping can not be made with aerobic free radical inhibitors alone because especially at high temperature conditions (for example, during drying after coating, inappropriate transporting or during preheat before development) the compositions tend to polymerize without exposure resulting in insufficient shelf life.

The concentrations of each of the aerobic and anaerobic free radical inhibitors in the radiation-sensitive composition or imageable layer - if present at all - are independently from about 0.001 to about 2 weight %, or from about 0.003 to about 0.5 weight % based on the total dry weight. The molar ratio of the aerobic free radical inhibitor to the anaerobic free radical inhibitor is preferably from about 1:1 to about 200: 1.

The layer(s) may furthermore comprise inorganic particles such as surface-modified silica fumed silica particles and sol-gel silica particles, that - if present at all - are present in an amount of from about 1 to about 40 weight %, and preferably have an average particle size of from about 1 to about 500 nm. The presence of the surface-modified silica particles may provide improved abrasion resistance, reduced tackiness, and various other desired properties.

### Overcoat

An oxygen-impermeable overcoat can be applied over the photopolymerizable coating; "oxygen-impermeable" does not necessarily mean "impermeable to 100 %" but sufficient for protecting the coating from atmospheric oxygen during storage, exposure and in particular during the time between exposure and further processing in order to avoid undesired polymerization. During that time the overcoat has to exhibit sufficient adhesion to the light-sensitive coating so that safe handling (manufacture, packing, transport, exposure etc.) is guaranteed without tearing of the layers. In addition to its function as oxygen barrier layer the overcoat also protects the photopolymerizable coating from fingerprints and mechanical damage like scratches.

A number of whaler-soluble polymers are described in the literature as being suitable for such overcoats. Suitable examples are polyvinyl alcohol, partly saponified polyvinyl acetate having a saponification degree of from 70 to 99% and which can also contain vinylether and vinylacetal units, polyvinyl pyrrolidone and copolymers thereof with vinyl acetate and vinyl ethers, hydroxy alkyl cellulose, gelatin, polyacrylic acid, gum arabic, polyacryl amide, dextrin, cyclodextrin, copolymers of alkylvinyl ethers and maleic acid anhydride as well as water-soluble high molecular polymers of ethylene oxide having molecular weights of above 5,000 are particularly suitable. Polyvinyl alcohol is a preferred overcoat polymer. Also polyvinyl alcohol in combination with poly(1-vinylimidazole) or a copolymer of 1-vinyl-imidazole and at least one further monomer as described in WO 99/06890 can be used.

Polyvinyl alcohol can also be used in combination with polyvinyl pyrrolidone as adhesion promoter.

Overcoats are also described in US 3,458,311, US 4,072,527, US 4,072,528, EP 275 147 A1, EP 403 096 A1, EP 354 475 A1, EP 465 034 A1 and EP 352 630 A1.

In a preferred embodiment the overcoat comprises polyvinyl alcohol or polyvinyl alcohol in combination with poly(1-vinylimidazol) (or a copolymer thereof) and poly(vinyl pyrrolidone) (or a copolymer thereof).

Suitable polyvinyl alcohols are commercially available at inexpensive prices. They usually have a residual content of acetate groups in the range of 0.1 to 30 wt-%. Especially preferred are polyvinyl alcohols obtained from polyvinylacetate with a residual acetate content of 1.5 to 22 wt-%. By means of the molecular weight of the used polyvinyl alcohols, adhesion and water-solubility of the overcoats can be controlled. A lower molecular weight promotes the removal of the overcoat with aqueous solutions.

The water-soluble overcoats can be applied by means of surface coating methods known to the skilled practician such as doctor blade coating, roller coating, slot coating, curtain coating, spray or dipping processes. Dry layer weights of from 0.05 to 10 g/m², more preferably 0.2 to 3 g/m². most preferably 0.3 to 1 g/m² are suitable.

In many cases it is favorable to apply the water-soluble overcoats in an aqueous solution. This has the least detrimental effects on the environment and the human body.

For some applications, however, it can also be favorable to use organic solvents. In some substrates the addition of 0.5 to 60 wt-% of an organic solvent to the aqueous coating solution improves adhesion. By means of a slight solvation of the surface to be overcoated, the adhesive effect of the polymers of the overcoats according to the present invention is increased further. Such additives to solvents can e. g. be alcohols or ketones.

For a uniform and rapid wetting of the surface to be coated, anionic, cationic or non-ionic wetting agents may be added to the coating solutions. The overcoat furthermore can comprise stabilizers, preservatives, dyeing agents, foam separators and rheological additives.

### IMAGEWISE EXPOSURE

If the absorber component used in the photopolymerizable coating absorbs UV/VIS radiation, the precursors are imagewise exposed in a manner known to the person skilled in the art with UV/VIS radiation of a wavelength of 250 to 750 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 ± 10 nm), argon ion lasers emitting in the visible range (488 nm or 514 nm) and frequency-doubled fd:Nd:YAC lasers emitting at around 532 nm are of particular interest as a radiation source. The laser radiation can be digitally controlled via a computer, i.e. it can be turned on or off so that an imagewise exposure of the plates can be effected via stored digitized information in the computer; this way, so-called computer-to-plate (ctp) printing plates can be obtained.

If the absorber component absorbs IR radiation, i.e. noticeably absorbs radiation of a wavelength in the range of more than 750 to 1,200 nm, and preferably shows an absorption maximum in this range in its absorption spectrum, imagewise exposure can be carried out with IR radiation sources. Suitable radiation sources are e.g. semi-conductor lasers or laser diodes which emit in the range of 750 to 1200 nm. for example Nd:YAG lasers (1,064 nm), laser diodes which emit between 790 and 990 nm, and Ti:sapphire lasers. The laser radiation can be digitally controlled via a computer, i.e. it can be turned on or off so that an imagewise exposure of the plates can be effected via stored digitized information in the computer; this way, so-called computer-to-plate (ctp) printing plates can be obtained. Any image-setters equipped with IR lasers that are known to the person skilled in the art can be used.

The imagewise exposed precuror comprises exposed and unexposed areas of the coating.

### PROCESSING OF THE EXPOSED PRECURSOR

After imagewise exposure the precursor is treated with the developer in order to remove the coating in the non-image (i.e. non-exposed) areas thereby revealing the substrate in said areas.

If the precursor comprises an overcoat which protects the radiation sensitive coating, the overcoat can be removed by washing/rinsing with water before applying the developer. According to one embodiment the overcoat is not removed in a separate step but is removed together with the non-image areas of the radiation sensitive coating in a single step by treating the exposed precursor with a suitably selected alkaline developer.

After removing the non-image areas of the coating (and optionally the overcoat) with the developer, the treated precursor can be dried.

According to another embodiment after removing the non-image areas of the coating (and optionally the overcoat) with the developer, the treated precursor can be rinsed with water.

According to a further embodiment after removing the non-image areas of the coating (and optionally the overcoat) with the developer and rinsing the precursor with water it is possible to apply a hydrophilic finishing gum.

According to one embodiment treating an exposed precursor with a developer results in (1) removing of the overcoat in the exposed and unexposed areas (if an overcoat is present at all or was not removed before the treatment with the developer), (2) removing of the non-image areas of the radiation sensitive coating, and (3) providing of a protective gumming in one single step provided that the developer is selected accordingly.

Typically, the exposed precursor is contacted with the developer by rubbing or wiping the imageable layer with an applicator containing this liquid. Alternatively, the exposed precursor may be brushed with the developer or the developer may be applied to the precursor by spraying. The treatment with the developer can also be carried out by immersing the exposed precursor in a bath of the developer. According to one embodiment, the processing may be carried out in a commercially available processor, such as TDP 60 (Horsell) which contains only one bath for the developer and a drying section. Additionally, a conductivity-measuring unit can be incorporated into the processor.

According to another embodiment, conventional processors equipped with an immersion type developing bath, a section for rinsing with water, a gumming section, and a drying section, can be used. Additionally, a conductivity-measuring unit can be incorporated into the processor for controlling the developer activity of the developer.

The exposed precursor is typically treated with the developer at a temperature of 18°C to about 28°C, for a period of about 5 seconds to about 60 seconds.

After a certain number of exposed precursors have been processed, the developing activity (for instance measured by titration or conductivity measurement) of a developer bath falls below a predetermine level. Then fresh developer is added to the bath (also called "top-up" process). Usually about 20 mL to about 200 mL, typically about 30-120 mL, of fresh developer per 1 m² of precursor processed is necessary to keep both the volume of developer and its activity/conductivity value constant. The processed lithographic printing plate, comprises regions in which imageable layer has been removed revealing the underling surface of the hydrophilic substrate, and complimentary regions in which the imageable layer has not been removed. The regions in which the imageable layer has not been removed are ink receptive.

Instead of adding fresh developer for keeping the activity of the developer bath constant a replenisher can be added. The replenisher suitably differs from the fresh developer in that the concentration of the alkaline reagent is higher compared to the concentration of the alkaline reagent in the fresh developer used; the concentration of the other components might be the same or higher as in the fresh developer.

After having contacted the precursor with the developer any excess of said developer remaining on the precursor is removed (for instance by means of squeeze rollers; washing/rinsing the precursor with a liquid like water etc). After a subsequent optional drying step the processed precursor can be transferred to the press. On the press the processed precursor is contacted with fountain solution and printing ink, either simultaneously or subsequently (in any order, but preferably first fountain solution and thereafter ink). By contacting the precursor with the fountain solution and ink and thereafter with paper any remainders of undesired coating (radiation-sensitive coating in the non-image areas and/or overcoat) which have not already been removed by the treatment with the developer are removed.

### Developer

The developer used in the method of the present invention is an aqueous solution having a pH value of >6, preferably a pH of from 7.5 to 13.5, more preferably a pH of from 8 to 12.

### Water

Tap water, deionized water or distilled water can be used. The amount of water is preferably in the range of 45 to 98 wt-%, based on the total weight of the developer, especially preferred 50 to 95 wt-% and particularly preferred 80 to 95 wt-%.

### Alkaline component

The developer used in the present invention may comprise an alkaline component.

The alkaline component can for instance be selected from alkali silicates, alkali hydroxides, Na₃PO₄, K₃PO₄, NR₄OH, wherein each R is independently selected from C₁-C₄ alkyl groups and C₁-C₄ hydroxyalkyl groups, amines and mixtures of 2 or more of the foregoing.

The amount of the alkaline component, or in case of mixtures the total amount of the alkaline components, is preferably selected such that the pH value of the developer is >6 to 14, preferably, the pH is in the range of 7.5 to 13.5, more preferably in the range of 8 to 12.

As used in the present invention, the term "alkali silicates" also encompasses metasilicates and water glasses. Sodium silicates and potassium silicates are preferred silicates. When alkali silicates are used, the amount of silicate is preferably at least 1 wt-% (calculated as SiO₂), based on the developer.

Of the alkali hydroxides, NaOH and KOH are especially preferred.

Usually the use of alkali metasilicates readily provides a pH value of more than 12 without further alkaline additives such as e.g. alkali hydroxide. When water glass is used, an alkali hydroxide is used in addition if a pH value of more than 12 is desired.

Preferred quaternary ammonium hydroxides NR₄OH include for example tetramethyl ammonium hydroxide, trimethylethanol ammonium hydroxide, methyltriethanol ammonium hydroxide and mixtures thereof; an especially preferred ammonium hydroxide is tetramethyl ammonium hydroxide.

Suitable amines are primary, secundary and tertiary amines. Examples are mono- and dialkanol amines like monoethanol amine and diethanol amine.

### Surfactant

An optional component of the developer used in the present invention is the surfactant.

The surfactant is not specifically limited as long as it is compatible with the other components of the developer and soluble in aqueous alkaline solutions with a pH of >6. The surfactant can be a cationic, an anionic, an amphoteric or a nonionic one.

Examples of anionic surfactants include hydroxyalkanesulfonates, alkylsulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylethers, salts of phosphoric esters of polyoxyethylenealkylphenylethers, partially saponified compounds of styrenemaleic anhydride copolymers, partially saponified compounds of olefin-maleic anhydride copolymers, naphthalenesulfonateformalin condensates, sodium dodecyl-phenoxybenzene disulfonates, the sodium salts of alkylated naphthalenesulfonate, disodium methylene-dinaphtalene-disulfonate, sodium dodecyl-benzenesulfonate, (di)sulfonated alkyldiphenyloxides, ammonium or potassium perfluoroalkylsulfonates and sodium dioctyl-sulfosuccinate.

Particularly preferred among these anionic surfactants are alkylnaphthalenesulfonates, disulfonated alkyldiphenyloxides, and alkylsulfonates.

Suitable examples of the nonionic surfactants include polyoxyethylene alkyl ethers, polyoxyethylene phenyl ethers, polyoxyethylene 2-naphthyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolaminealiphatic esters, and trialkylamine oxides. Particularly preferred among these nonionic surfactants are polyoxyethylene phenyl ethers and polyoxyethylene-2-naphthyl ethers.

Further, fluorine containing and silicone anionic and nonionic surfactants may be similarly used.

Amphoteric surfactants are for example N-alkylamino acid triethanol ammonium salts, cocamidopropyl betaines, cocamidoalkyl glycinates, sodium salt of a short chain alkylaminocarboxylate, N-2-hydroxyethyl-N-2-carboxyethyl fatty acid amidoethylamin sodium salts, and carboxcylic acid amidoetherpropionates; preferred are cocamidopropylbetaines.

Examples of cationic surfactants are tetraalkyl ammoniumchlorides like tetrabutyl ammoniumchloride and tetramethyl ammoniumchloride, and polypropoxylated quaternary ammonium chlorides.

Nonionic, anionic and amphoteric surfactants as well as mixtures thereof are preferred.

It is preferred that the developer used in the present invention comprises at least one member selected from surfactants and alkaline components.

Two or more of the above surfactants may be used in combination. The amount of the surfactant (or total amount of surfactants if more than one is used) is not specifically limited but is preferably from 0.01 to 20 wt-%, more preferably from 2 to 8 wt-% based on the total weight of the developer.

### Water-soluble film forming hydrophilic polymer

One optional component of the developer is a water-soluble film forming hydrophilic polymer. The use of such a polymer is especially suitable if a "single step processing" (i.e. developing and gumming in one process step) is desired.

Examples of suitable polymers are gum arabic, pullulan, cellulose derivatives such as hydroxymethyl celluloses, carboxymethylcelluloses, carboxyethylcelluloses or methyl-celluloses, starch derivatives like (cyclo)dextrins, poly(vinyl alcohol), poly(vinyl pyrrolidone), polyhydroxy compounds like polysaccharides, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid and acrylamidopropane sulfonic acid, polyhydroxy compounds and starch derivatives.

Polyhydroxy compounds and starch derivatives are especially preferred. The starch derivative should be water-soluble, preferably cold-water-soluble and is selected from starch hydrolysis products such as dextrins and cyclodextrins, starch esters, such as phosphate esters and carbamate esters, starch ethers, such as e.g. cationic starch ethers and hydroxypropyl ethers, carboxymethyl starch and acetylated starch; from the above derivatives dextrins (including dextrin comprising sodium tetraborate and available as borax dextrin from Emsland Stärke GmbH) are preferred.

The starch used as a starting product for the starch derivatives can be of various origins, it can e.g. be obtained from corn, potatoes, rye, wheat, rice, manioc, tapioca, chestnuts or acorns; corn starch and potato starch are preferred.

Suitable water-soluble polyhydroxy compounds can be represented by the following structure:

R¹(CHOH)ₙR²

in which n is 4 to 7; and
either (i) R¹ is hydrogen, aryl, or CH₂OH; and R² is hydrogen, an alkyl group having 1 to 4 carbon atoms, CH₂OR³ in which R³ is hydrogen or an alkyl group having 1 to 4 carbon atoms, CH₂N(R⁴R⁵) in which R⁴ and R⁵ are each independently hydrogen or an alkyl group having 1 to 4 carbon atoms, or CO₂H,
or (ii) R¹ and R² together form a carbon-carbon single bond.

In one group of polyhydroxy compounds, R¹ is hydrogen or CH₂OH and R² is hydrogen. In a preferred group of these polyhydroxy compounds, n is 5 or 6. This group includes the sugar alcohols, compounds of the structure H(CHOH)ₙH, which do not carry a free aldehyde or ketone group and do not show a reducing property. The sugar alcohols may be obtained from natural sources or prepared by hydrogenation of reducing sugars. Preferred sugar alcohols include mannitol, sorbitol, xylitol, ribitol, and arabitol. Other sugar alcohols include, for example, talitol, dulcitol, and allodulcitol.

In another group of polyhydroxy compounds, R¹ and R² together form a carbon-carbon single bond. Included are carbocyclic compounds of the structure: (CHOH)ₙ, in which n is 4 to 7. In a preferred group of these polyhydroxy compounds, n is 5 or 6, more preferably 6. There are nine possible stereoisomers of 1,2,3,4,5,6-hexahydroxycyclohexane, several of which are naturally occurring. A preferred polyhydroxy compound is meso-inosit (cis-1,2,3,5-trans-4,6-hexahydroxycyclohexane). meso-Inosit can be isolated from corn steep liquor.

In another group of polyhydroxy compounds, R¹ is hydrogen, aryl, or CH₂OH; and R² is an alkyl group having 1 to 4 carbon atoms, CH₂OR³ in which R³ is all alkyl group having 1 to 4 carbon atoms, CH₂N(R⁴R⁵) in which R⁴ and R⁵ are each independently H or an alkyl group having 1 to 4 carbon atoms, or CO₂H.

In another group of polyhydroxy compounds, R¹ is hydrogen or CH₂OH; and R² is CO₂H. More preferably, R¹ is H and n is 4 or 5. This group includes polyhydroxy compounds of the structure H(CHOH)ₙCO₂H, in which n is 4 or 5. Conceptually, these polyhydroxy compounds may be produced by oxidation of the corresponding hexose or pentose sugar, i.e., oxidation of the aldehyde group of a hexose sugar such as glucose, galactose, allose, mannose, etc., or oxidation of the aldehyde of a pentose sugar such as arabinose, ribose, xylose, etc.

Particularly preferred polyhydroxy compounds are the sugar alcohols mentioned above, like sorbitol.

The amount of the film forming polymer is not specifically limited; preferably - if present at all - it is from 1 to 30 wt-% based on the total weight of the developer, more preferably from 5 to 20 wt-%.

### Further optional components of the developer

Besides the essential components and the above-cited optional components the developer used in the present invention may contain further additives like organic solvents, biocides, complexing agents, buffer substances, dyes, antifoaming agents, odorants, anticorrosive agents and radical inhibitors.

### Antifoaming agents:

Suitable antifoaming agents include e.g. the commercially available Silicone Antifoam Emulsion SE57 (Wacker), TRITON^{®} CF32 (Rohm & Haas), AKYPO^{®} LF (ethercarboxylic acid Chem Y), Agitan 190 (Münzing Chemise), TEGO^{®} Foamese 825 (modified polysiloxane, TEGO Chemie Service GmbH, Germany). Silicone-based antifoaming agents are preferred. They are either dispersible or soluble in water. The amount of antifoaming agent in the developer is preferably 0 to 1 wt-%, based on the weight of the developer especially preferred 0.01 to 0.5 wt-%. One antifoaming agent or a mixture of two or more can be used.

### Buffers:

Suitable buffer substances include e.g. tris(hydroxymethyl)-aminomethane (TRIS), hydrogen phosphates, glycine, 3-(cyclohexylamino)-propane sulfonic acid (CAPS), hydrogen carbonates, borates including borax, 2-amino-2-methyl-1-propanol (AMP), 3-(cyclohexylamino)-2-hydroxy-1-propane-sulfonic acid (CAPSO), and 2-(N-cyclohexylamino)ethan-sulfonic acid (CHES).

### Biocides:

The biocides should be effective against bacteria, fungi and/or yeasts. Suitable biocides include e.g. N-methylol-chloroacetamide, benzoic acid, p-hydroxybenzoic acid esters, phenol or its derivatives, formalin, imidazol derivatives, isothiazolinone derivatives like 1,2-benziso-thiazolin-3-on, benzotriazole derivatives, amidines, guanidine derivatives, quaternary ammonium salts, pyridine, quinoline derivatives, diazine, triazole derivatives, oxazole and oxazine derivatives and mixtures thereof. Their mount is not particularly restricted and preferably accounts for 0 to 10 wt-% in the developer, based on the total weight of the solution, especially preferred 0.1 to 1 wt-%. One biocide or a mixture of two or more can be used.

### Complexing agents:

Examples of suitable complexing agents include: Aminopolycarboxylic acid and salts thereof, such as ethylene diamine tetraacetic acid and potassium or sodium salts thereof, diethylene triamine pentaacetic acid and potassium or sodium salts thereof, triethylene tetraamino-hexaacetic acid and potassium or sodium salts thereof, hydroxyethyl ethylene diamine triacetic acid and potassium or sodium salts thereof, nitrilotriacetic acid and potassium or sodium salts thereof, 1,2-diaminocyclohexane-tetraacetic acid and potassium or sodium salts thereof and 1,3-diamino-2-propanol-tetraacetic acid and potassium or sodium salts thereof, and an organo-phosphonic acid, phosphonoalkane tricarboxylic acid or salts thereof, such as 2-phosphonobutane-1,2,4-tricaboxylic acid and potassium or sodium salts thereof, phosphonobutane-2,3,4-tricarboxylic acid and potassium or sodium salts thereof, phosphonoethane-2,2,2-tricarboxylic acid and potassium or sodium salts thereof, aminotris-(methylene-phosphonic acid) and potassium or sodium salts thereof and sodium gluconate. The complexing agents can be used individually or as a combination of two or more. Organic amine salts of the above-mentioned complexing agents can be used instead of the potassium or sodium salts thereof. The amount of complexing agent preferably accounts for 0 to 5 wt-% in the developer, based on the total weight of the solution, especially preferred 0.01 to 1 wt-%.

### Solvents:

The developer may also comprise an organic solvent or a mixture of organic solvents. The developer is a single phase. Consequently, the organic solvent must be miscible with water, or at least soluble in the developer to the extent it is added to the developer, so that phase separation does not occur. The following solvents and mixtures of these solvents are suitable for use in the developer: the reaction products of phenol with ethylene oxide and propylene oxide, such as ethylene glycol phenyl ether; benzyl alcohol; esters of ethylene glycol and of propylene glycol with acids having six or fewer carbon atoms, and ethers of ethylene glycol, diethylene glycol, and of propylene glycol with alkyl groups having six or fewer carbon atoms, such as 2-ethylethanol and 2-butoxyethanol. A single organic solvent or a mixture of organic solvents can be used. The organic solvent is typically present in the developer at a concentration of between about 0 wt-% to about 15 wt-%, based on the weight of the developer preferably between about 3 wt-% and about 5 wt-%, based on the weight of the developer.

### "Sludge inhibitors":

As described in detail in US 6,383,717 B1 and US 6,482,578 B2 sludge may be formed in a developer bath due to the build up of free-radical polymerizable material in the case of negative working precursors where imaging is based on free-radical polymerization in the coating of the precursor. Sludge formation may be prevented by the presence of at least one material selected from filter dyes and free-radical inhibitors in the developer. Filter dyes absorb ambient ultraviolet and visible radiation and reduce the amount absorbed by the radiation-sensitive initiator system present in the loaded developer. Free-radical inhibitors inhibit free-radical polymerization of the monomer in the loaded developer.

The absorption of the filter dye is matched to the absorption of the radiation-sensitive initiator system, furthermore the filter dye should be stable in the developer and should not undergo any chemical reaction or interaction with the components of the developer, or the radiation-sensitive layer.

The concentration of filter dye required to produce the stabilizing effect under daylight or similar conditions will depend on the number of factors; however, the concentration of the filter dye is preferably about 0 to 2 wt-%, based on the weight of the developer, preferably about 0.4 % to 2 wt-%, based on the weight of the developer.

The filter dye must be sufficiently soluble in the developer that enough filter dye can be dissolved in the developer to absorb radiation in the region about 350 nm to about 650 nm region of the spectrum. Dyes substituted with one or more sulfonic acid groups will typically have sufficient solubility in the developer. Preferred dyes include yellowish, yellow, orange and red dyes substituted with sulfonic acid groups. Especially preferred are sulfonated azo dyes. Suitable dyes include, for example, metanil yellow (C.I. 13065) and other similar water-soluble azo dyes, such as, for example, methyl orange (C.I. 13025), tropaeoline O (C.I. 14270), tropaeoline OO (C.I. 13080), tartrazine (C.I. 19140); Oxonol Yellow K (Riedel-de-Haen); dyes of the acid yellow type, such as C.I. 13900, C.I. 14170, C.I. 18835, C.I. 18965, C.I. 18890, C.I. 18900, C.I. 18950 (polar yellow), C.I. 22910, and C.I. 25135; and dyes of the acid red type, such as C.I. 14710, C.I. 14900, C.I. 17045, C.I. 18050, C.I. 18070, and C.I. 22890. Other suitable dyes will be readily apparent to those skilled in the art. A single filter dye or a mixture of filter dyes can be used.

Suitable free-radical inhibitors, also known as polymer stabilizers or free-radical traps, are well known in the art of monomer and polymer stabilization.

Any material that is capable of reacting with free-radicals to form products that do not initiate polymerization of the monomer, that has the necessary solubility and stability in the developer, and that does not adversely affect the properties of either the developer or the printing plate can potentially be used. They include, for example: compounds containing quinone or hydroquinone moieties, especially benzoquinone and substituted benzoquinones, and hydroquinone and substituted hydroquinones, such as hydroquinone monomethyl ether (4-methoxyphenol), t-butylhydroquinone (4-t-butylphenol, TBHQ), and t-butyl hydroxyanisol (BHA); recorcinol, pyrrogallol. phosphate esters; and hindered phenols and bisphenols, such as 2,6-di-t-butyl-4-methylphenol (BHT), and 2,6-di-t-butyl-4-methoxyphenol, 2,4,6-tri-t-butylphenol; stable free-radicals, such as di-t-butyl nitroxide and 2,2,6,6-tetramethyl-4-pyridone nitroxide; nitro substituted aromatics; amino phenols; phenothiazine; and secondary diaryl amines such as substituted diphenyl amines, N,N'-diphenyl-p-phenylenediamine, and N-phenyl-naphthyl amine. Preferred radical inhibitors are quinones, hydroquinones, ethers of hydroquinones, and hindered phenols. More preferred are ethers of hydroquinones, especially ethers of hydroquinone and hindered phenols. Preferred compounds are hydroquinone monomethyl ether (4-methoxyphenol), 2,6-di-t-butyl-4-methylphenol, and 2,4,6-tri-t-butylphenol. A single free-radical inhibitor or a mixture of free-radical inhibitors can be used. The free-radical inhibitor or a mixture of free-radical inhibitors is typically present in the developer at a concentration of about 0 wt-% to about 3.0 wt-% based on the weight of the developer, preferably about 0.5 wt-% to about 1.5 wt-%, based on the weight of the developer.

### Anticorrosive agents:

Examples of anticorrosive agents are phosphonic acids and their salts like hydroxyethyl phosphonic acid and its salts, amino trismethylene phosphonic acid and its salts, and diethylentriaminpentamethylene phosphonic acid and its salts; phosphates like trisodium phosphate; borates like borax; as well as glycerol and glycols having the formula 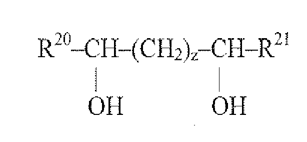 (wherein z is 0, 1 or 2 and R²⁰ and R²¹ are independently hydrogen or C₁-C₃ alkyl).

The anticorrosive agent or mixture of such agents is typically present in the developer at a concentration of about 0 to 10 wt-% based on the weight of the developer, preferably 0.1 to 5 wt-%, in case of glycerol or a glycol 5 to 10 wt-%.

### Further additives:

Odorants and dyes can also be present in the developer, if desired. The dyes are added in order to prevent confusion at the users when different processing chemicals like developer and replenisher are used parallel at the same user. Examples for classes of dyes that can be used are azo dyes, triarylmethan dyes or phthalocyanines. The concentration of the dyes in the developer is typically 0.0005 to 0.5 wt.-%.

Odorants are used in order to compensate unpleasant smell of other components in the developer. The typical concentration of odorants is within 0.001 to 1 wt.-%.

The present invention is described in more details in the following examples; however they are not intended to restrict the invention in any way.

### Examples

The following abbreviations are used:

| | |
|---|---|
| MEK | methyl ethyl ketone |
| UA02 | urethane acrylate, reaction product of Desmodur®N100, GDMA and PPGMA |
| CN2302 | hyperbranched polyester acrylate obtained from Sartomer |
| PAM-100 | ethylene glycol methacrylate phosphate obtained from Rhodia |
| CIB | dicumene iodonium tetraphenyl borate |
| S2024 | IR dye obtained from FEW (λₘₐₓ (MeOH) = 793 nm) |
| | 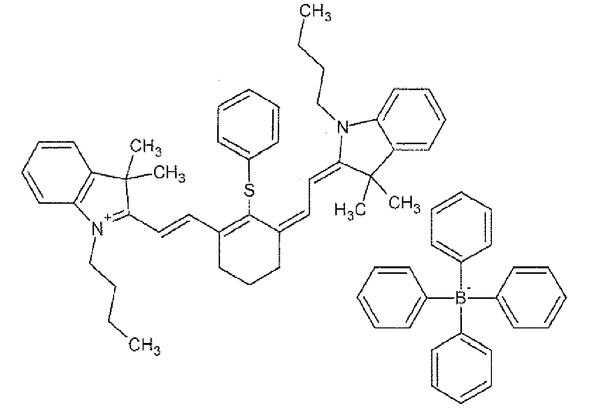 |
| Mikuni Cyan A037M | pigment dispersion obtained from Mikuni |
| V-59 | 2,2'-Azobis(2-methylbutyronitrile) obtained from Wako |
| Dowanol® PM | propylene glycol methyl ether obtained from Dow Chemical |
| Mowiol 8-88 | polyvinylalcohol obtained from Kuraray |
| Sokalan PA40 | homopolymere of acrylic acid obtained from BASF |
| Texapon 842 | anionic surfactant obtained from Cognis |
| Ethylan HB4 | aromatic ethoxylate obtained from Akzo Nobel |
| HQME | hydroquinone methylether obtained from Sigma Aldrich |
| SE-57 | defoaming emulsion obtained from Wacker |
| Dowanol EPH | 2-phenoxyethanol obtained from Dow Chemical |
| Hydropalat 3204 | chelating agent obtained from Cognis |
| Trilon B | chelating agent obtained from BASF |
| Trilon BS | chelating agent obtained from BASF |
| Desmodur® N100 | trifunctional isocyanate (biuret of hexamethylene diisocyanate) |
| GDMA | glycerin dimethacrylate, obtainable from Sigma Aldrich |
| PPGMA | polypropylene glycol methacrylate, obtainable from Sigma Aldrich |
| DAA | dimethylacetamid, obtainable from Sigma Aldrich |

### Preparation of Binder Polymer

### General Procedure

A 14 wt% solution of the monomers in MEK was prepared and 0.5 mol% dodecyl mercaptane and 0.6 mol% V-59 was added in an N₂ atmosphere. The reaction mixture was heated to 70°C for 22 h and stirred under N₂ protection. Then, most of the solvent was removed and the resulting mixture was treated with methanol; the precipitated polymer was filtered off and dried in a vacuum oven at 30°C overnight.

### Preparation of Polymer A (Invention)

Polymer A was prepared according to the above-mentioned General Procedure using methacrylic acid/ethylene glycol dicyclopentenyl methacrylate/benzyl methacrylate/polyethylene glycol methacrylate in a molar ratio of 20/50/25/5.

### Preparation of Polymer B (Invention)

Polymer B was prepared according to the above-mentioned General Procedure using mono-2-(methacryloyloxy)ethyl maleate/ethylene glycol dicyclopentenyl methacrylate/benzyl methacrylate/polyethylene glycol methacrylate in a molar ratio of 20/50/25/5.

### Preparation of Polymer C (Invention)

Polymer C was prepared according to the above-mentioned General Procedure using mono-2-(methacryloyloxy)ethyl maleate/ethylene glycol dicyclopentenyl methacrylate/dicyclopentadienyl methacrylate/polyethylene glycol methacrylate in a molar ratio of 20/50/20/10.

### Preparation of Polymer D (Invention)

Polymer D was prepared according to the above-mentioned General Procedure using mono-2-(methacryloyloxy)ethyl maleate/ethylene glycol dicyclopentenyl methacrylate/polyethylene glycol methacrylate in a molar ratio of 25/70/5.

### Preparation of Polymer E (Invention)

Polymer E was prepared according to the above-mentioned General Procedure using mono-2-**(methacryloyloxy)ethyl maleate/ethylene glycol dicyclopentenyl methacrytate/N-isopropyt acrylamide/polyethylene glycol methacrylate in a molar ratio of 20/60/15/5.**

### Preparation of Polymer F (Comparative)

Polymer F was prepared according to the above-mentioned General Procedure using methacrylic acid/allyl methacrylate/benzyl methacrylate in a molar ratio of 20/60/20.

### Preparation of Polymer G (Comparative)

Polymer G was prepared according to the above-mentioned General Procedure using methacrylic acid/ethylene glycol dicyclopentenyl methacrylate/benzyl methacrylate/polyethylene glycol methacrylate in a molar ratio of 20/25/50/5.

### Preparation of Precursors

### General Procedure

An imageable layer formulation was prepared as detailed in Table 1. The formulation was applied to an electrochemically grained aluminum substrate that has been post-treated with an aqueous solution of polyvinyl phosphoric acid and the coating was dried to a film weight of 1.2 g/m². Then, said imageable layer was coated with an aqueous solution of Mowiol 8-88 to provide an overcoat having a dry coating weight of 0.8 g/m².

**Table 1**

| Component | Weight in g |
|---|---|
| Binder polymer | 0.7600 |
| UA 02 | 1.4330 |
| CN 2302 | 0.4334 |
| PAM-100 | 0.0666 |
| CIB | 0.0500 |
| S2024 | 0.0300 |
| 3-mercapto-1,2,4-triazol | 0.0500 |
| Mikuni Cyan A037M | 0.7500 |
| Dowanol PM | 9.7254 |
| MEK | 2.0946 |

### Example 1: Preparation of Precursor A

Precursor A was prepared according to the above mentioned General Procedure using Polymer A as binder polymer.

### Example 2: Preparation of Precursor B

Precursor B was prepared according to the above mentioned General Procedure using Polymer B as binder polymer.

### Example 3: Preparation of Precursor C

Precursor C was prepared according to the above mentioned General Procedure using Polymer C as binder polymer.

### Example 4: Preparation of Precursor D

Precursor D was prepared according to the above mentioned General Procedure using Polymer D as binder polymer.

### Example 5: Preparation of Precursor E

Precursor E was prepared according to the above mentioned General Procedure using Polymer E as binder polymer.

### Comparative Example 1: Preparation of Precursor F

Precursor F was prepared according to the above mentioned General Procedure using Polymer F as binder polymer.

### Comparative Example 2: Preparation of Precursor G

Precursor G was prepared according to the above mentioned General Procedure using Polymer G as binder polymer.

### Imaging of the Precursors

The resulting precursors were placed on a Kodak® Trendsetter 800 II Quantum platesetter (830 nm) using a gray scale wedge with defined tonal values for evaluating the quality of the copies and exposed at 80 mJ/cm² using a 830 nm IR laser. Then, the imageable layer was developed in a single bath processor, AGFA® C95, with processing solutions as detailed in Tables 2 and 3; by treating the exposed precursors with the processing solution the overcoat was removed as well as the unexposed areas of the imageable layer and in addition a protective gumming was provided.

**Table 2: Processing Solution 1**

| Component | Weight% | |
|---|---|---|
| Sokalan PA40 (35 wt%) | 5 | |
| Texapon 842 | 5 | |
| Diethanolamine | 2 | |
| Ethylan HB4 | 0.2 | |
| HQME | 1 | pH 10.4 |
| Water | 86.8 | |

**Table 3: Processing Solution 2**

| Component | Weight% | |
|---|---|---|
| SE57 | 0.027 | |
| Texapon 842 | 9.257 | |
| Diethanolamine | 1.789 | |
| Ethylan HB4 | 0.154 | |
| p-Tolucne sulfonic acid | 0.180 | |
| Dowanol EPH | 4.121 | |
| Hydropalat 3204 | 1.286 | pH 9.9 |
| Trilon B | 1.286 | |
| Trilon BS | 0.062 | |
| Water | 81,838 | |

### Evaluation of the Imaged Plates

To evaluate the developability, unexposed 8 cm x 15 cm plate stripes were immersed gradually in the two different processing solutions such that every 5 seconds 3 cm more were immersed in the bath. After a total of dwell time of 60 seconds the strips were removed from the developer bath and the developing time was determined as the time necessary to completely remove the coating. The results can be seen in Table 4.

The sensitivity of the precursors (i.e. their speed) was evaluated by the use of the gray scale wedge with an exposure at 80mJ/cm². The more solid areas of the gray scale wedge are obtained after exposure and development the higher the speed of the precursor. The results can be seen in Table 4.

**Table 4**

| | Processing Solution 1 | | Processing Solution 2 | |
|---|---|---|---|---|
| | Greyscale (solid) | Developing time (s) | Greyscale (solid) | Developing time (s) |
| Example 1 | 3-4 | 5 | 3 | 5 |
| Example 2 | 3-4 | 5 | 3 | 5 |
| Example 3 | 3-4 | 5 | 3 | 5 |
| Example 4 | 3-4 | 5 | 3 | 5 |
| Example 5 | 3-4 | 5 | 3 | 5 |
| Comp. Example 1 | 1-2 | nd | 2 | 40 |
| Comp. Example 2 | 2 | 5 | 2 | 5 |

| | | | | |
|---|---|---|---|---|
| nd = not developable | | | | |

As is apparent from Table 4 the precursors according to the present invention can be developed and gummed in a single step within a very short time while the comparative precursor needs a very long time for development which is not suitable for practice. In addition, the precursors according to the present invention showed a higher speed than the comparative precursors.

### Evaluation of Solvent resistance:

To evaluate the crosslinking degree and the resistance of the polymer coating the plates were dipped in a DAA/water solution (80:20) for 1h and then dried in an oven at 60°C for 1h. The weight loss of the plates was determined (cf. table 5).

**Table 5**

| | Weight loss mg/dm² |
|---|---|
| Example 1 | 1.1 |
| Example 2 | 1.3 |
| Example 3 | 0.7 |
| Example 4 | 0.8 |
| Example 5 | 0.5 |
| Comp. Example 1 | 2.2 |
| Comp. Example 2 | 5.4 |

## Claims

1. Negative working lithographic printing plate precursor, comprising:
(a) a substrate with a hydrophilic surface on at least one side thereof
(b) an imageable coating on the hydrophilic surface of the substrate, comprising:
(i) at least one low molecular weight free-radical polymerizable component
(ii) at least one radical forming component selected from photoinitiators and sensitizer/coinitiator systems which absorbs radiation of a wavelength in the range of 250 to 1200 nm and is capable of initiating a free-radical polymerization
and
(iii) at least one polymeric binder comprising repeating units A, B, and optionally C
-(A)ₓ-, -(B)_{y}-, -(C)ₜ-,
wherein x is 5 to 30 mol%
y is 40 to 85 mol%
t is 0 to 60 mol%
A is at least one repeating unit comprising at least one pendant acid group
B is at least one repeating unit comprising at least one pendant ethylenically unsaturated group which is an integral part of a bi- or polycyclic structure
and
C is at least one repeating unit derived from a (meth)acrylic acid ester or a (meth)acrylamide
and optionally
(c) an oxygen-impermeable overcoat.

2. Precursor according to claim 1, wherein the imageable layer comprises a sensitizer absorbing radiation of a wavelength between 750 and 1200 nm.

3. Precursor according to claim 1 or 2, wherein the imageable layer comprises a coinitiator selected from iodonium compounds.

4. Precursor according to claim 3, wherein the coinitiator has a boron containing anion.

5. Precursor according to any one of claim 1 to 4, wherein the aliphatic bi- or polycyclic structure is selected from a norbornene, norbornadieue, dicyclopentene, dicyclohexene, and dicyclopentadiene moiety.

6. Precursor according to any one of claims 1 to 5, wherein A is at least one repeating unit comprising both at least one pendant acidic group and at least one ethylenically unsaturated alicyclic pendant group.

7. Precursor according to claim 6, wherein the polymeric binder (iii) comprises units A derived from mono-2-((meth)acryloyloxy)ethyl maleate.

8. Precursor according to any one of claims 1 to 7, wherein in polymeric binder (iii) the total content of units comprising ethylenically unsaturated groups is 40 mol% to 95 mol%.

9. Precursor according to any one of claims 1 to 8, wherein the polymeric binder (iii) comprises
10 to 25 mol% repeating unit A derived from mono-2-((meth)acryloyloxy)ethyl maleate;
45 to 75 mol% repeating unit B derived from at least one of ethylene glycol dicyclopentenyl (meth)acrylate, dicyclopentenyl ether (meth)acrylate, ethylene glycol norbornenyl (meth)acrylate and norbornenyl (neth)acrylate; and
5 to 30 mol% repeating unit C derived from at least one of ethylene glycol (mcth)acrylate, propylene glycol (meth)acrylate, poly(ethylene glycol) (meth)acrylate, poly(propylene glycol) (meth)acrylate, 2-aminoethyl (meth)acrylate, 2-(N-alkyl)aminoethyl (meth)acrylate, 2-(N,N-dialkyl)aminoethyl (meth)acrylate, benzyl (meth)acrylate, cyclohexyl (meth)acrylate, isobornyl (meth)acrylate, allyl (meth)acrylate, or N-allyl (meth)acrylamide.

10. Precursor according to any one of claims 1 to 9, wherein the imageable coating further comprises
(iv) one or more non-reactive binders selected from phenolic resins and copolymers of (meth)acrylic acid, N-phenylmaleimide and (meth)acrylamide; and
optionally
(v) anaerobic or aerobic radical polymerization inhibitors.

11. Method for imaging a lithographic printing plate precursor as defined in any of claims 1 to 10, comprising:
a) imagewise exposure to radiation to which the imageable layer of the precursor is sensitive
b) removing the non-exposed areas of the imageable layer by an aqueous solution.

12. Method according to claim 11, wherein the aqueous solution used in step (b) is an aqueous alkaline developer.

13. Method according to claim 11, wherein in step (b) developing and gumming are carried out in a single step without intermediate washing step by using an alkaline developer comprising a film forming hydrophilic polymer.

14. Method according to claim 11, wherein the precursor comprises an oxygen-impermeable overcoat and, wherein in step (b) the overcoat as well as the non-exposed areas of the imageable layer are removed and a protective gumming is provided in a single step without intermediate washing step(s).

15. Use of a composition comprising
(i) at least one low molecular weight free-radical polymerizable component
(ii) at least one radical forming component selected from photoinitiators and sensitizer/coinitiator systems which absorbs radiation of a wavelength in the range of 250 to 1200 nm and is capable of initiating a free-radical polymerization
and
(iii) at least one polymeric binder comprising repeating units A, B, and optionally C,
-(A)ₓ-, -(B)_{y}-, -(C)ₜ-,
wherein x is 5 to 30 mol%
y is 40 to 85 mol%
t is 0 to 60 mol%
A is at least one repeating unit comprising at least one pendant acid group
B is at least one repeating unit comprising at least one pendant ethylenically unsaturated group which is an integral part of a bi- or polycyclic structure
and
C is at least one repeating unit derived from a (nmeth)acrylic acid ester or a (meth)acrylamide
for the preparation of a negative working lithographic printing plate precursor, photomask, resist compositions, micro-optical devices, printed circuit boards, lacquers and molding compositions.
